# EUROPEAN PATENT APPLICATION

(11) **EP 4 845 337 A2**
(43) Date of publication of application: **25.11.2026**
(21) Application number: 26179195.8
(22) Date of filing: 18.05.2026
(51) Int. Cl.: H10D 30/62, H10D 30/60, H10D 62/10, H10D 62/13

(54) **MULTIGATE SEMICONDUCTOR DEVICES WITH NATIVE REGIONS**

(30) Priority: 21.05.2025 US 202519214744
(71) Applicant: Avago Technologies International Sales Pte. Limited, Singapore 768923 (SG)
(72) Inventor: Loo, Sim, Irvine, 92618 (US); Ito, Akira, Irvine, 92618 (US)
(74) Representative: Bosch Jehle Patentanwaltsgesellschaft mbH

(57) **Abstract**

An example multigate semiconductor device with varied threshold voltages includes a channel, a source disposed on the channel, a drain disposed on the channel, a first gate disposed on the channel between the source and the drain, a second gate disposed on the channel between the first gate and the drain, and/or a native region disposed below at least a portion of the channel. In some examples, the first gate comprises a first metal and the second gate comprises a second metal that is different from the first metal.

## Description

The present disclosure relates, in general, to semiconductor device technology. Semiconductor device structures including fin field-effect transistors (FinFET) and, more specifically, laterally diffused metal-oxide-semiconductors (LDMOS), can be used in high-power applications such as power amplifiers, radio frequency (RF) amplifiers, and power transistors for radio and wireless communication systems. As the demand for high-power applications increases, research and development efforts continue to advance semiconductor technologies to meet manufacturing capabilities and capacities of foundries and enhance the functionality of various electronic devices and circuits.

According to an aspect of the invention, a semiconductor device is provided, comprising:
a channel;
a source disposed on the channel;
a drain disposed on the channel;
a first gate comprising a first metal disposed on the channel between the source and the drain;
a second gate comprising a second metal disposed on the channel between the first gate and the drain, the second metal being different from the first metal; and
a native region disposed below at least a portion of the channel.

Advantageously, the semiconductor device further comprises:
a p-type well; and
an n-type well.

Advantageously:
the native region is disposed within the p-type well and/or displaces at least a portion of the p-type well.

Advantageously:
the native region is disposed within the p-type well and/or displaces at least a portion of the n-type well.

Advantageously:
a first portion of the native region is disposed within the p-type well and/or displaces at least a portion of the p-type well; and
a second portion of the native region is disposed within the n-type well and/or displaces at least a portion of the n-type well.

Advantageously:
the native region separates the p-type well from the n-type well.

Advantageously:
the native region shares a layer with the p-type well and/or the n-type well and is more lightly doped than the p-type well and/or the n-type well.

Advantageously:
the native region is disposed at least partially beneath the first gate.

Advantageously:
the native region is disposed at least partially beneath the second gate.

Advantageously:
the native region is disposed at least partially beneath the first gate and the second gate.

Advantageously, the semiconductor device further comprises a substrate, wherein the native region and the substrate are doped at approximately the same level.

Advantageously, the semiconductor device further comprises a substrate, wherein the native region is contiguous with the substrate.

Advantageously, the native region is in direct contact with the channel.

Advantageously, the second metal is different from the first metal such that the first gate has a first threshold voltage and the second gate has a second threshold voltage, the second threshold voltage being greater than the first threshold voltage.

Advantageously:
the first gate comprises a first active gate;
the second gate comprises a second active gate; and
the semiconductor device comprises a dummy gate disposed on the channel between the second gate and the drain.

According to an aspect, a semiconductor device comprises:
a substrate; a channel; a p-type well; an n-type well;
a source disposed on the channel;
a drain disposed on the channel;
a first gate comprising a first metal disposed on the channel between the source and the drain;
a second gate comprising a second metal disposed on the channel between the first gate and the drain, the second metal being different from the first metal; and
a native region.

Advantageously:
the native region is disposed within the p-type well and/or displaces at least a portion of the p-type well.

Advantageously:
the native region is disposed within the p-type well and/or displaces at least a portion of the n-type well.

Advantageously:
the native region is disposed under at least a portion of the first gate and at least a portion of the second gate;
a first portion of the native region is disposed within the p-type well and/or displaces at least a portion of the p-type well; and
a second portion of the native region is disposed within the n-type well and/or displaces at least a portion of the n-type well.

According to an aspect, a semiconductor device comprises:
a substrate;
a channel;
a source disposed on the channel;
a drain disposed on the channel;
a first gate comprising a first metal disposed on the channel between the source and the drain;
a second gate comprising a second metal disposed on the channel between the first gate and the drain, the second metal being different from the first metal; and
a native region contiguous with the substrate and in direct contact with at least a portion of the channel.

### Brief Description of the Drawings

Fig. 1A shows a top view illustrating a first example semiconductor device with a native region in a first configuration, in accordance with some aspects of the disclosure.
Fig. 1B shows a cross section view illustrating the example semiconductor device of Fig. 1A, in accordance with some aspects of the disclosure.
Fig. 1C shows a top view illustrating the first example semiconductor device with a native region in a second configuration, in accordance with some aspects of the disclosure.
Fig. 1D shows a cross section view illustrating the example semiconductor device of Fig. 1C, in accordance with some aspects of the disclosure.
Fig. 1E shows a top view illustrating the first semiconductor device with a native region in a third configuration, in accordance with some aspects of the disclosure.
Fig. 1F shows a cross section view illustrating the example semiconductor device of Fig. 1E, in accordance with some aspects of the disclosure.
Fig. 2A shows a top view illustrating a second example semiconductor device with a native region in a first configuration, in accordance with some aspects of the disclosure.
Fig. 2B shows a cross section view illustrating the example semiconductor device of Fig. 2A, in accordance with some aspects of the disclosure.
Fig. 2C shows a top view illustrating the second example semiconductor device with a native region in a second configuration, in accordance with some aspects of the disclosure.
Fig. 2D shows a cross section view illustrating the example semiconductor device of Fig. 2C, in accordance with some aspects of the disclosure.
Fig. 2E shows a top view illustrating the second example semiconductor device with a native region in a third configuration, in accordance with some aspects of the disclosure.
Fig. 2F shows a cross section view illustrating the example semiconductor device of Fig. 2E, in accordance with some aspects of the disclosure.
Fig. 3A shows a top view illustrating a third example semiconductor device with a native region in a first configuration, in accordance with some aspects of the disclosure.
Fig. 3B shows a cross section view illustrating the example semiconductor device of Fig. 3A, in accordance with some aspects of the disclosure.
Fig. 3C shows a top view illustrating the third example semiconductor device with a native region in a second configuration, in accordance with some aspects of the disclosure.
Fig. 3D shows a cross section view illustrating the example semiconductor device of Fig. 3C, in accordance with some aspects of the disclosure.
Fig. 3E shows a top view illustrating the third example semiconductor device with a native region in a third configuration, in accordance with some aspects of the disclosure.
Fig. 3F shows a cross section view illustrating the example semiconductor device of Fig. 3E, in accordance with some aspects of the disclosure.
Fig. 4A shows a top view illustrating a fourth example semiconductor device with a native region in a first configuration, in accordance with some aspects of the disclosure.
Fig. 4B shows a cross section view illustrating the example semiconductor device of Fig. 4A, in accordance with some aspects of the disclosure.
Fig. 4C shows a top view illustrating the fourth example semiconductor device with a native region in a second configuration, in accordance with some aspects of the disclosure.
Fig. 4D shows a cross section view illustrating the example semiconductor device of Fig. 4C, in accordance with some aspects of the disclosure.
Fig. 4E shows a top view illustrating the fourth example semiconductor device with a native region in a third configuration, in accordance with some aspects of the disclosure.
Fig. 4F shows a cross section view illustrating the example semiconductor device of Fig. 4E, in accordance with some aspects of the disclosure.

### Detailed Description

As described in further detail below, some embodiments provide semiconductor devices with native regions inserted in one or more levels above the substrate. As discussed in the '322 Application, one way to improve hot carrier injection (HCl) device degradation is to alter the current flow and/or electrical fields by using metals with different work function to form active gates. The inventors hereof have discovered that native region insertion can provide further benefits, additionally and/or alternatively to employing metals with different work functions for different active gates. For example, including a native region can provide more flexibility (*i.e.,* additional adjustable parameters, or "process knobs," that can be tuned in semiconductor processing) to achieve better device reliability and/or performance.

Embodiments can provide a variety of FINFet LMDOS gate structures and native region configurations, and this disclosure provides examples of four different gate structures, each with three different possible native region configurations, but the skilled artisan should recognize, based on the disclosure herein, that other gate structures and/or native region configurations are possible in accordance with various embodiments.

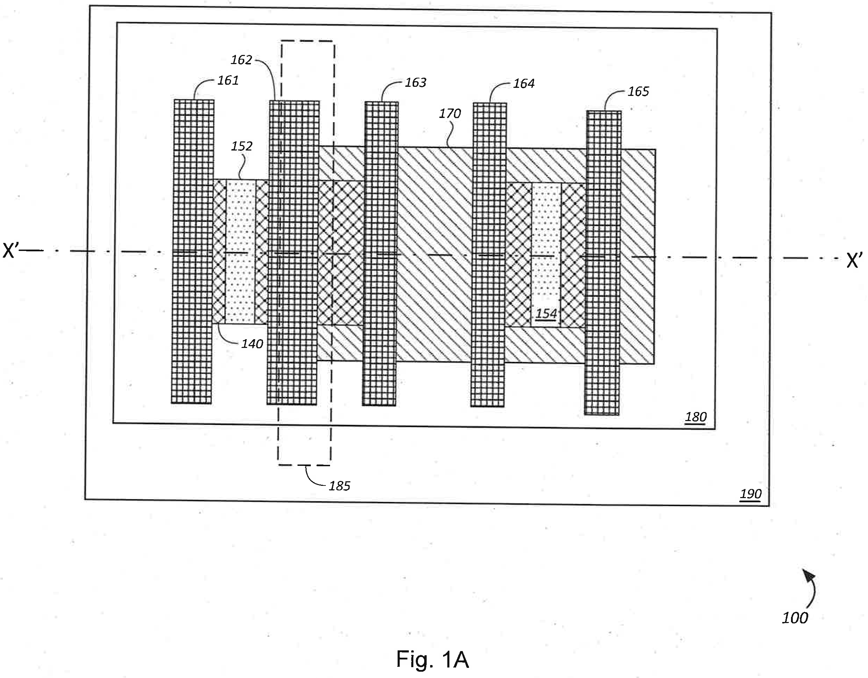

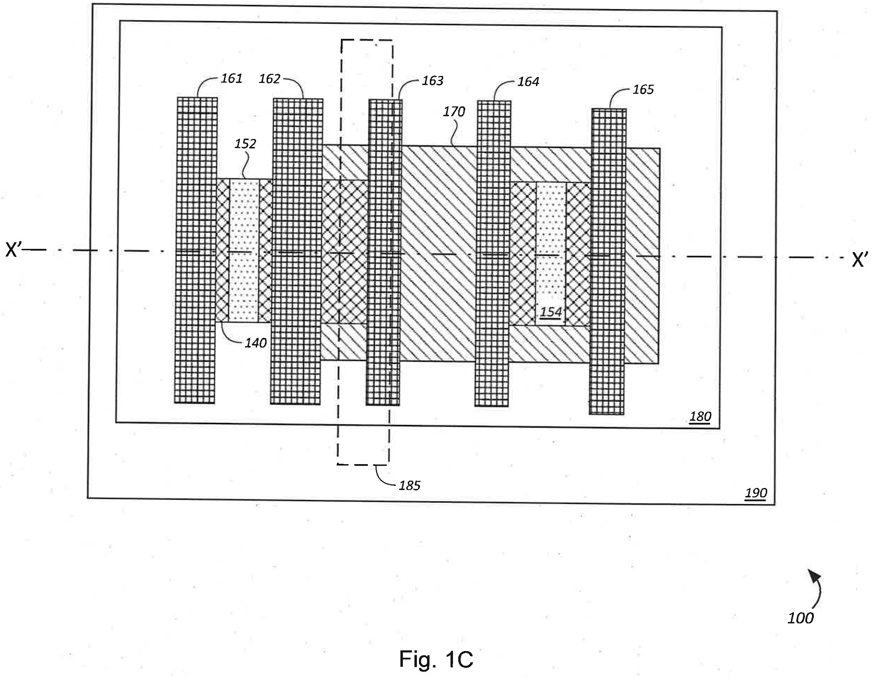

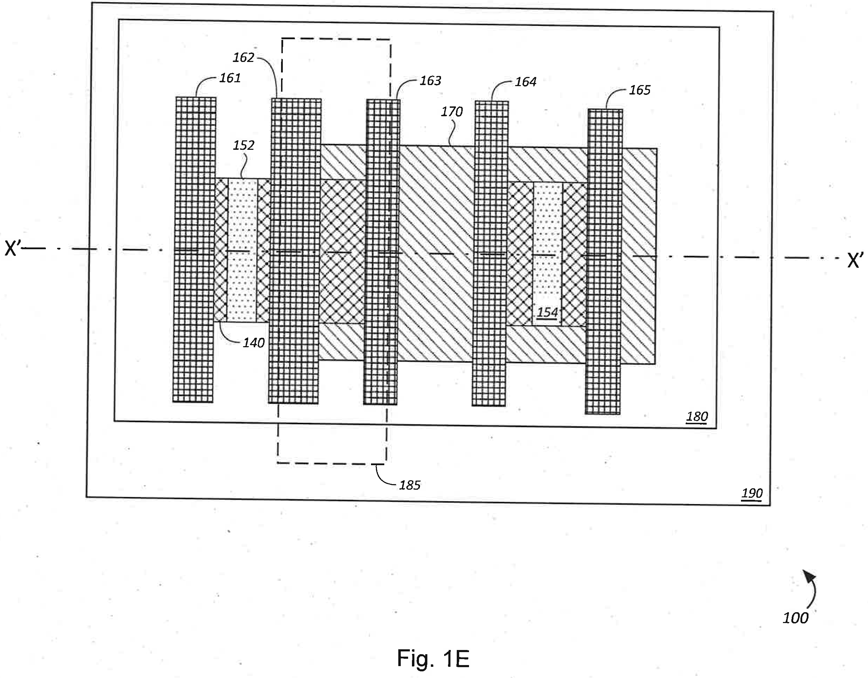

Figs. 1A-1F illustrate a first example semiconductor device with 100 with a first gate structure. Figs. 1A-1B illustrate a first set of embodiments comprising the first example semiconductor device 100, in which a native region is inserted in a p-type well and/or under a first gate; Figs. 1C-1D illustrate another set of embodiments comprising the first example semiconductor device 100, in which a native region is inserted in an n-type well and/or under a second gate; and Figs. 1E-1F illustrate a third set of embodiments comprising the first example semiconductor device 100, in which a native region is disposed in both a p-type well and an n-type well. Other than the disposition of the native region, the semiconductor devices 100 illustrated by Figs. 1A-1F are substantially similar.

Referring to Fig. 1A, a top view illustrating an example semiconductor device 100 is shown, in accordance with some aspects of the disclosure. The semiconductor device 100 can be implemented as a variety of types of semiconductor devices, such as various different types and combinations of transistor structures. For example, the semiconductor device 100 can be a non-planar (three-dimensional) FinFET device such as, for example, an LDMOS device. As shown in Fig. 1A, the semiconductor device 100 includes an example channel 140. The channel 140 can be implemented in a variety of ways using a variety suitable materials and/or combinations of materials. For example, the channel 140 can include a conductive silicon fin in implementations where the semiconductor device 100 is a FinFET device. The channel 140 can also include any other suitable type of conductive fin or other channel-type structure used in the semiconductor device 100. The semiconductor device 100 is also shown to include a plurality of gates including a gate 161, a gate 162, a gate 163, a gate 164, and a gate 165. The semiconductor device 100 is further shown to include a source 152, a drain 154, and a trench 170 formed in the channel 140 and between the gate 163 and the drain 154. The semiconductor device 100 is also shown to include an oxide diffusion layer 190 (e.g., a thick oxide layer, etc.) and a doped layer 180 (e.g., an N+ buried layer, a deep n-well layer, etc.).

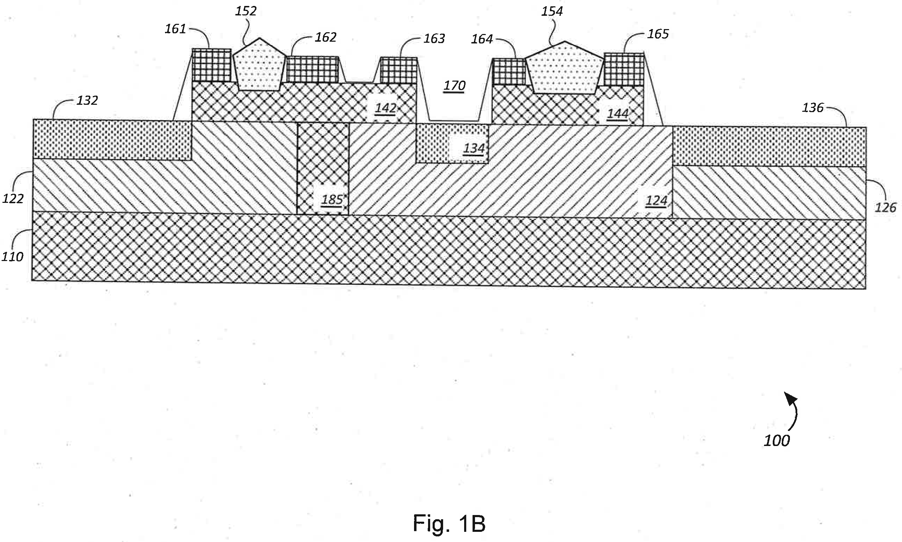

Referring to Fig. 1B, a cross section view illustrating the example semiconductor device 100 is shown, in accordance with some aspects of the disclosure. The illustrated cross section of the semiconductor device 100 as shown in Fig. 1B can be taken along the line X' as shown in Fig. 1A, for example. In the cross section of the semiconductor device 100 as shown in Fig. 1B, the source 152, the drain 154, the gate 161, the gate 162, the gate 163, the gate 164, and the gate 165 can all be seen. Additionally, the trench 170 can be seen, where the trench 170 is formed between two separate regions of the channel 140: a channel region 142 and a channel region 144. In the cross section of the semiconductor device 100 as shown in Fig. 1B, additional layers can also be seen, including a substrate 110, a p-type well 122, an n-type well 124, a p-type well 126, an isolation structure 132, an isolation structure 134, an isolation structure 136, and various oxide layers (e.g., gate oxide layers, etc.) formed around and/or between the source 152, the drain 154, the gate 161, the gate 162, the gate 163, the gate 164, the gate 165, the channel region 142, and the channel region 144.

The substrate 110 can be formed of silicon material (e.g., crystalline silicon) and/or other suitable materials or combinations of materials. The substrate 110 can be implemented using various fabrication technologies, such as using a silicon-on-insulator (SOI) structure, a bulk semiconductor structure, an alloy semiconductor, a compound semiconductor, germanium, and/or various other suitable materials and combinations thereof. The substrate 110 can generally provide a base for forming components of the semiconductor device 100 thereon. The semiconductor device 100 can be implemented in a variety of different types of circuits, inducing various types of integrated circuit (IC) chips built on various types of substrates.

The p-type well 122 and the p-type well 126 can be regions of the semiconductor device 100 that are doped using one or more suitable p-type dopants such as, for example, boron and/or other p-type dopants. The n-type well 124 can be a region of the semiconductor device 100 that is doped using one or more suitable n-type dopants such as arsenic, phosphorous, and/or other n-type dopants. The p-type well 122, the n-type well 124, and the p-type well 126 can be regions of the substrate 110 such that the p-type well 122, the n-type well 124, and the p-type well 126 include doped silicon material, for example. The p-type well 122, the n-type well 124, and the p-type well 126 can also be formed at least partially separate from the substrate 110. For example, the p-type well 122, the n-type well 124, and the p-type well 126 can be formed at least partially within various types of oxide layers and/or other insulating/dielectric layers of the semiconductor device 100. Notably, as shown in Fig. 1B, the isolation structure 134, the gate 163, and the trench 170 can be disposed over the n-type well 124. As a result of this structure, the region of the semiconductor device 100 between the gate 163 and the gate 164 can serve as a depletion region. The depletion region within the semiconductor device 100 can deplete charge carriers and thereby limit the amount of current that can flow through the depletion region, enabling the semiconductor device 100 to operate under higher voltage conditions. The doping polarities of the p-type well 122, the n-type well 124, and the p-type well 126 can be reversed in some applications (e.g., to provide a PLDMOS device instead of an LDMOS device).

The isolation structure 132, the isolation structure 134, and the isolation structure 136 can be shallow trench isolation (STI) structures, for example, among other possible types of dielectric layers. The isolation structure 132, the isolation structure 134, and the isolation structure 136 can be formed as a result of etching trenches in the semiconductor device 100. For example, after etching the trench 170 in the channel 140 and the n-type well 124, the isolation structure 134 can be formed by depositing a dielectric material at least partially within the trench 170. The dielectric material used to form the isolation structure 132, the isolation structure 134, and the isolation structure 136 can be, for example, silicon oxide, silicon nitride, and/or other suitable materials and combinations of materials. The isolation structure 132, the isolation structure 134, and the isolation structure 136 can prevent leakage of electric current between various components of the semiconductor device 100, for example.

The source 152 and the drain 154 can be implemented as epitaxial layers as part of the semiconductor device 100. For example, the source 152 and the drain 154 can be formed using various types of epitaxy processes and a variety of suitable epitaxial materials. The epitaxial materials can include, for example, silicon, gallium arsenide, and/or other suitable epitaxial materials and combinations thereof. In some examples, the source 152 and/or the drain 154 can be doped using suitable n-type or p-type dopants. Ultimately, the source 152 can be used to form a source terminal of a transistor (e.g., after forming a silicide layer and an interconnect on the epitaxial layer, etc.) and the drain 154 can be used to form a drain terminal of a transistor (e.g., after forming a silicide layer and an interconnect on the epitaxial layer, etc.). The source 152 can be disposed on the channel 140 between the gate 161 and the gate 162, and the drain 154 can be disposed on the channel 140 between the gate 164 and the gate 165. The source 152 and/or the drain 154 can be disposed directly on the channel 140 or there can be some materials and/or layers between the source 152 and/or the drain 154 and the channel 140.

In the semiconductor device 100, the gate 162 and the gate 163 can both be implemented as active gates such that the semiconductor device 100 is a multigate (split gate) device. That is, bias voltages that are applied at the gate 162 and the gate 163 can generally control operation and conductance of the semiconductor device 100. Then, in contrast, the gate 161, the gate 164, and the gate 165 can be implemented as "dummy" gates that are not active components of the semiconductor device 100, but can provide advantages in terms of the fabrication process for and the performance of the semiconductor device 100. The gate 161, the gate 164, and the gate 165 can be formed using polysilicon material and/or another suitable material or combination of materials.

The width of the gate 162 (as measured in the direction between the gate 161 and the gate 163 as shown in Fig. 1A) can be greater than the width of the gate 161, the width of the gate 164, and the width of the gate 165. Similarly, the width of the gate 163 (as measured in the direction between the gate 162 and the gate 164 as shown in Fig. 1A) can be greater than the width of the gate 161, the width of the gate 164, and the width of the gate 165. To provide advantages in terms of performance and durability, the width of the gate 162 and the width of the gate 163 can be between 50 nanometers and 360 nanometers, and the width of the gate 161, the width of the gate 164, and the width of the gate 165 can be between 50 nanometers and 100 nanometers. The gate 161, the gate 162, the gate 163, the gate 164, and the gate 165 can be disposed directly on the channel 140 or there can be some materials and/or layers between the gate 161, the gate 162, the gate 163, the gate 164, and the gate 165 and the channel 140 (e.g., gate oxide layers, etc.).

Relative to the semiconductor device 100, some alternate device structures may suffer from durability issues due to factors such as hot carrier injection (HCl) degradation, for example, among other possible factors. The durability issues can cause the overall device performance to degrade over time, and the durability issues can become even more prevalent especially as process node sizes continue to decrease with improvements in semiconductor fabrication technology. Moreover, as a result of process limitations associated with semiconductor fabrication technology (e.g., limitations of semiconductor fabrication plants), some approaches to improving device durability such as increasing channel length may not be feasible in various applications. However, the specific structure of the semiconductor device 100 can provide advantages in terms of improved durability relative to some alternate structures.

Notably, in the semiconductor device 100, the gate 162 can include and/or can be formed using a first metal, whereas the gate 163 can include and/or can be formed using a second metal that is different from the first metal. The second metal can be different from the first metal such that the gate 162 has a first threshold voltage (V_{T1}) and the gate 163 has a second threshold voltage (V_{T2}), where the second threshold voltage is greater than the first threshold voltage. This variance of the first threshold voltage and the second threshold voltage can alter the current flow and electrical fields within the semiconductor device 100 when compared to some alternate device structures in a manner that improves the durability of the semiconductor device 100. The first threshold voltage and the second threshold voltage can be the threshold bias voltage levels required to be applied to the gate 162 and the gate 163, respectively, to transition the semiconductor device 100 from an off state to an on state (e.g., the voltage levels required for current to flow through the semiconductor device 100).

By increasing the second threshold voltage relative to the first threshold voltage, the durability of the semiconductor device 100 (especially under higher operating voltage conditions) can be improved by reducing the effects of HCl degradation and/or other undesirable degradation effects that may otherwise occur. The second threshold voltage can be altered using the second metal in a variety of suitable manners. For example, the gate 163 can include a work function metal (e.g., the second metal) that increases the second threshold voltage relative to the first threshold voltage. The gate 163 can also be formed using an entirely different metal than the gate 162 in some implementations. The first metal can include molybdenum nitride, molybdenum, aluminum, tungsten nitride, titanium nitride, or tantalum nitride, for example. The second metal likewise can include molybdenum nitride, molybdenum, aluminum, tungsten nitride, titanium nitride, or tantalum nitride, for example.

As noted above, some embodiments, a semiconductor device 100 can include a native region inserted and/or disposed within one or more regions of the semiconductor device. The term "native region" is used broadly herein to refer to any region of a semiconductor that is more lightly-doped than the region(s) that are laterally adjacent to the native region; in some embodiments, the native region comprises the same material (e.g., silicon) and/or doping as the underlying substrate, but this is not required. Merely by way of example, Figs. 1A and 1B illustrate embodiments of the semiconductor device 100 comprising a native region 185 disposed beneath at least a portion of the channel 142. (In some embodiments, the native region 185 and/or an additional native region might be disposed beneath at least a portion of the channel 144.) As illustrated by Figs. 1A-1F, in some embodiments, the native region directly contacts the channel 142 (or at least a portion thereof). Also as illustrated by Figs. 1A-1F, in some embodiments, the native region 185 is contiguous with the substrate 110. The term, "contiguous" is used broadly herein to refer to any relationship between two elements, regions, and/or layers within a semiconductor device 100 (e.g., the native region 185 and the substrate 110, respectively) that are physically adjacent; are seamlessly connected; share a common boundary; and/or maintain consistent material, electrical, or doping properties without significant interruptions, barriers, or abrupt changes.

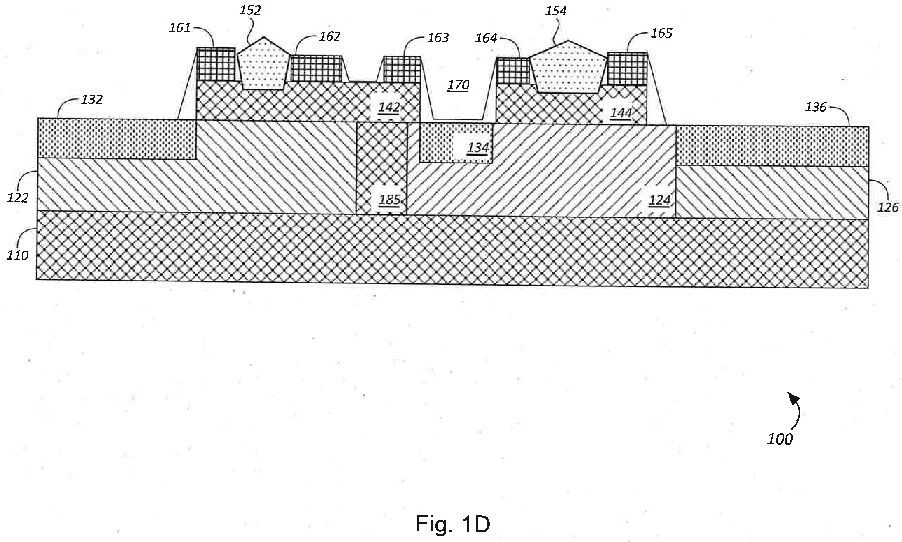

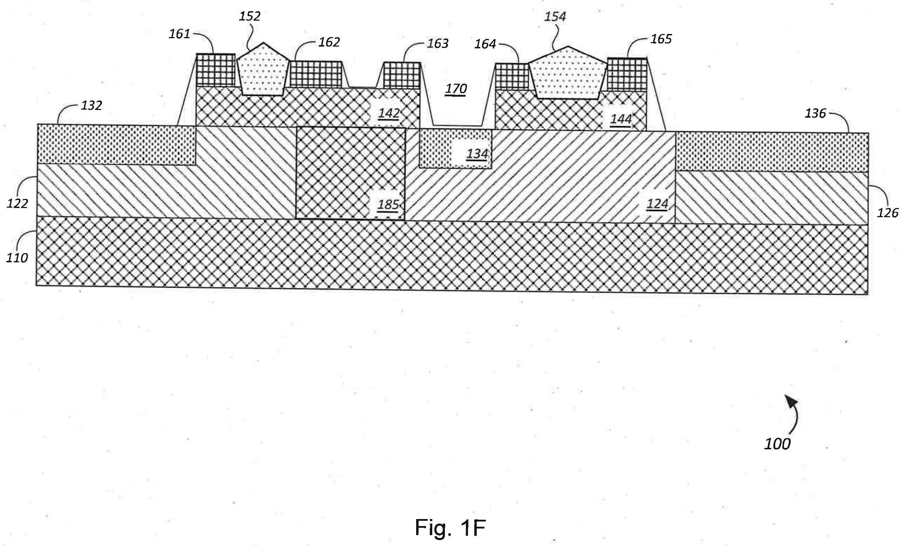

In some embodiments, the native region is disposed at least partially beneath the gate 162 and/or the gate 163. As used herein, the term "at least partially beneath," is used broadly to mean at least a portion of an element, e.g., the native region 185, is disposed beneath at least a portion of another element, *e.g*., the gate 162 and/or the gate 163. The term "at least partially beneath," does not require the two elements to be in direct contact unless the context clearly indicates otherwise. In some embodiments, the native region 185 is disposed in the p-type well 122 and/or displaces (*i.e.,* occupies a portion of the semiconductor that, in the absence of the native region 185, would be occupied by) a portion of the p-type well 122. Conversely, in the embodiments of the semiconductor device 100 illustrated by Figs. 1C and 1D, the native region 185 is disposed under the gate 163, *e.g*., within the n-type well 124 displacing a portion of the n-type well 124. In the embodiments of the semiconductor device 100 illustrated by Figs. 1E and 1F, the native region 185 is disposed below the gate 162 and the gate 163, *e.g*., disposed in (and/or displacing a portion of) both the p-type well 122 and the n-type well 124. In some embodiments , the native region 185 is contiguous and effectively sits between the p-type well 122 and n-type well 124.

In some embodiments, for example, in a semiconductor device 100 with an p-type substrate, the native region 185 might comprise a lightly doped native p-type substrate, using p-type dopants including without limitation those described elsewhere herein (*e.g.,* boron). Alternatively and/or additionally, *e.g.,* in a semiconductor device 100 with an n-type substrate, the native region 185 might be doped with n-type dopants, using n-type doping agents described elsewhere herein (*e.g*., phosphorus, arsenic, etc. As used herein, the term "lightly doped" is used to refer broadly to any level of doping that is lower than the level of doping of the p-type well 122 and/or the n-type well 124. In some embodiments, the native region 185 might be contiguous with the substrate 110 and/or might be doped at approximately the same level as the underlying substrate 110. As such, the native region 185 often will have significantly higher resistivity than the p-type well 122 and/or the n-type well 124.

When used in the context of doping, the term "level" refers to any relative or absolute measure of the amount of dopant in a region or layer (*e.g*., the p-type well 122, the n-type well 124, the native region 185, etc.). Merely by way of example, the p-type well 122 and n-type well might be doped at a level of ^{~}10¹⁷-10¹⁸ cm⁻³ (atoms/ cm³) with p-type and n-type dopants, respectively, while the native region 185 and substrate might be doped at a level of ~10¹⁴-10¹⁶ cm⁻³, orders of magnitude lower than the doping level of the p-type well 122 and the n-type well 124. It should be appreciated that these values are examples provided for illustration only, and different embodiments can have varying doping levels, depending on many implementation-specific details, such as the process node of the fabrication technology, the intended application of the semiconductor device 100 (*e.g*., RF vs. power), foundry process design kit and/or foundry capabilities, voltage and/or power requirements, thermal budget, layout constraints, size of the doped region, etc.

In some embodiments, for example, the substrate 110 might be masked in the native region 185, preventing the ion implantation that creates the p-type well 122 and/or the n-type well 124 from impregnating the native region 185, which thus might retain generally the same doping and/or doping level as the underlying substrate 110. In other embodiments, various other techniques known to the skilled artisan might be used to create the native region 185, including without limitation, counter-doping, deep well isolation, etc.

The presence of the native region 185 in the semiconductor device 100 can provide multiple benefits, such as increasing the breakdown voltage (BV) of the semiconductor device 100, which can enhance high-voltage operation, reducing electric field peaks near the drain 154, which can mitigate HCl degradation and thereby enhance long-term reliability, lowering parasitic capacitance, and/or providing isolation for devices (*e.g.*, transistors) on the semiconductor with lower threshold voltages. Moreover, as noted above, the use of a native region 185 can provide additional process knobs to tune the characteristics of the semiconductor 100 while still maintaining some or all of the advantages of using different metals for the materials of the gates 162 and 163, respectively. Merely by way of example, by adjusting the doping concentration, interface quality, doping gradient, location and/or size (in terms of both lateral size and/or depth) of the native region 185 to balance tradeoffs between the advantages (*e.g.,* as discussed above) of the native region 185 against other considerations, such as reducing on-resistance for better efficiency, thermal performance and/or current capacity. More generally, such process knobs can adjust how much the native region 185 counteracts the electrical properties of the p-type well 122 and/or the n-type well 124.

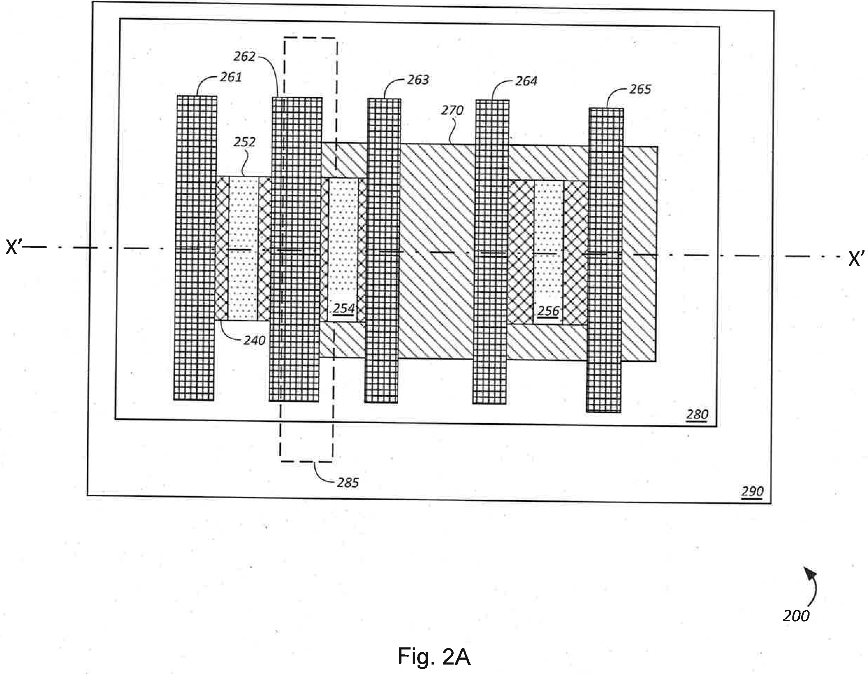

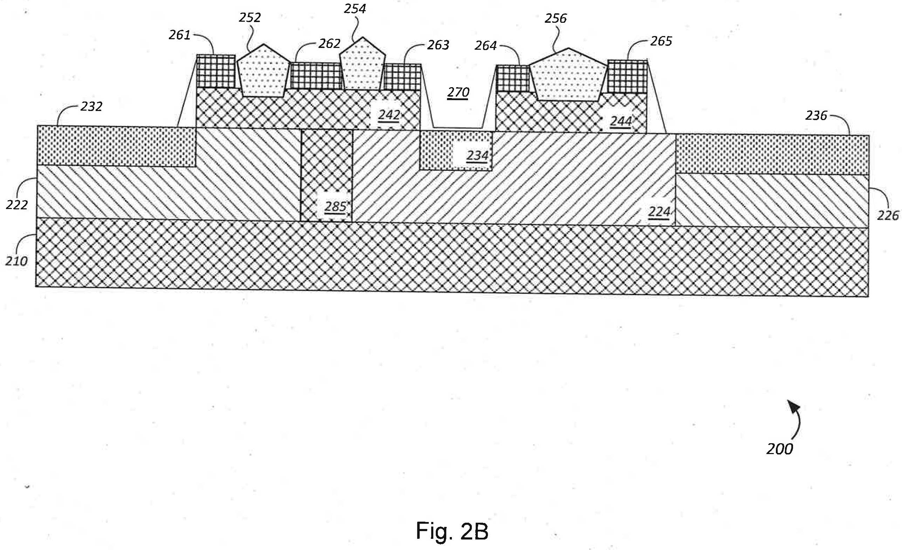

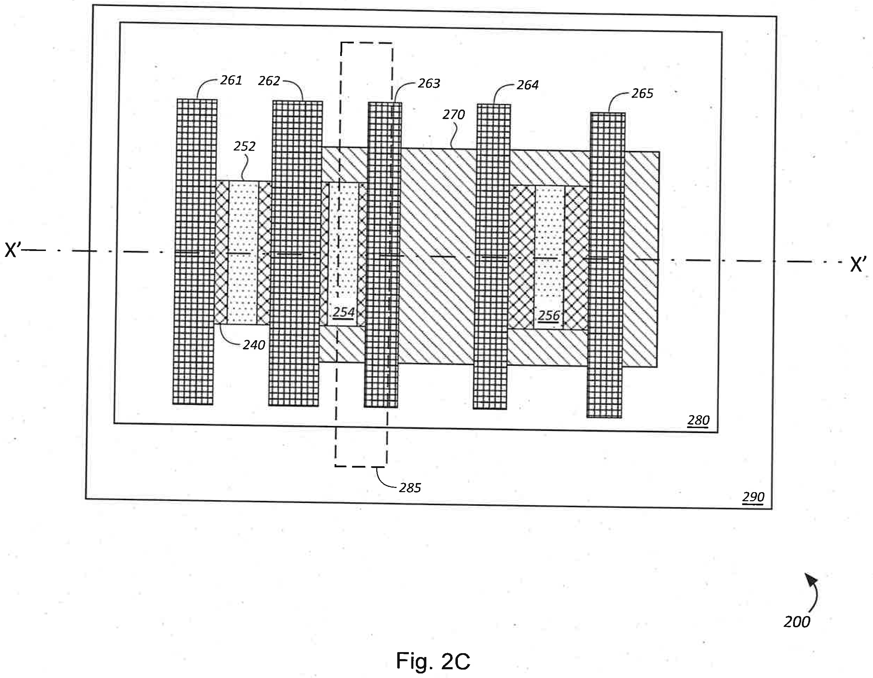

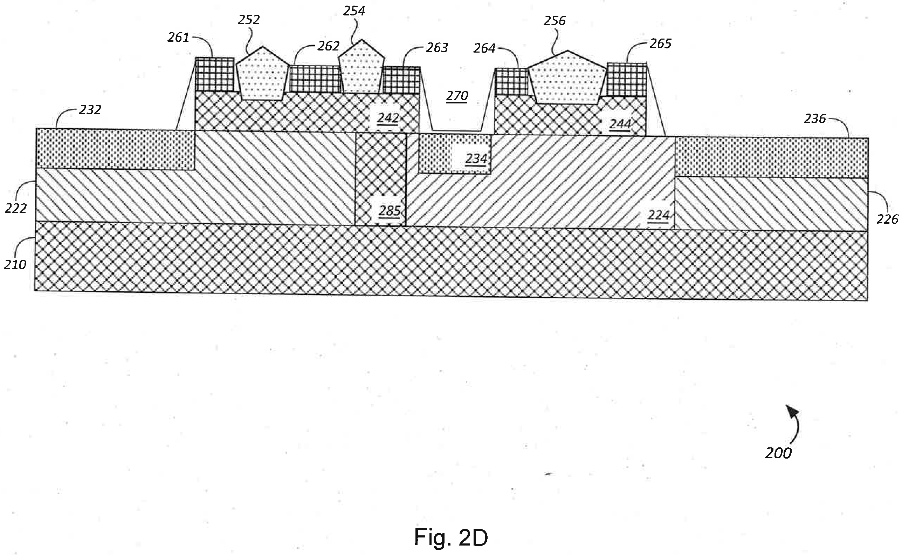

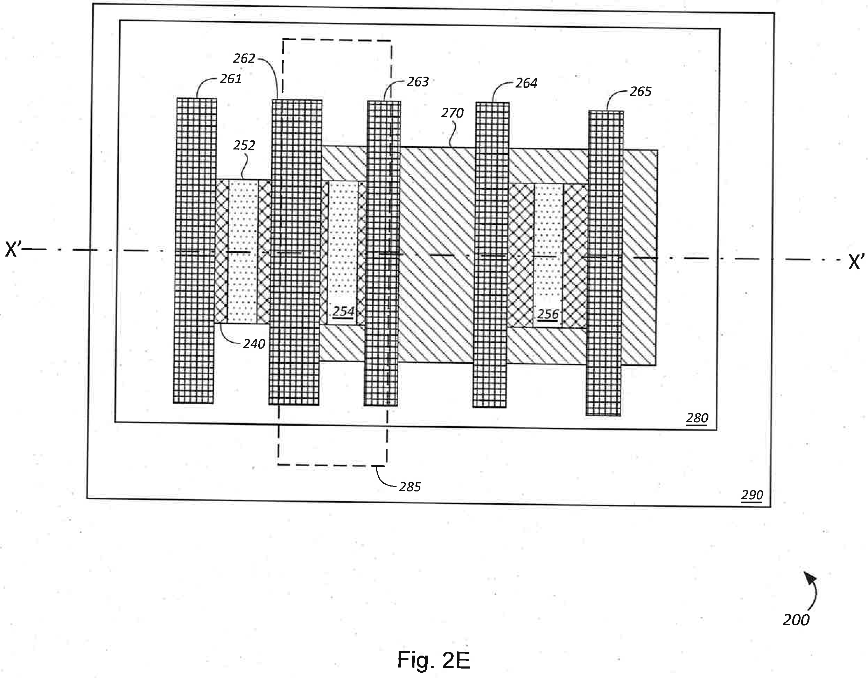

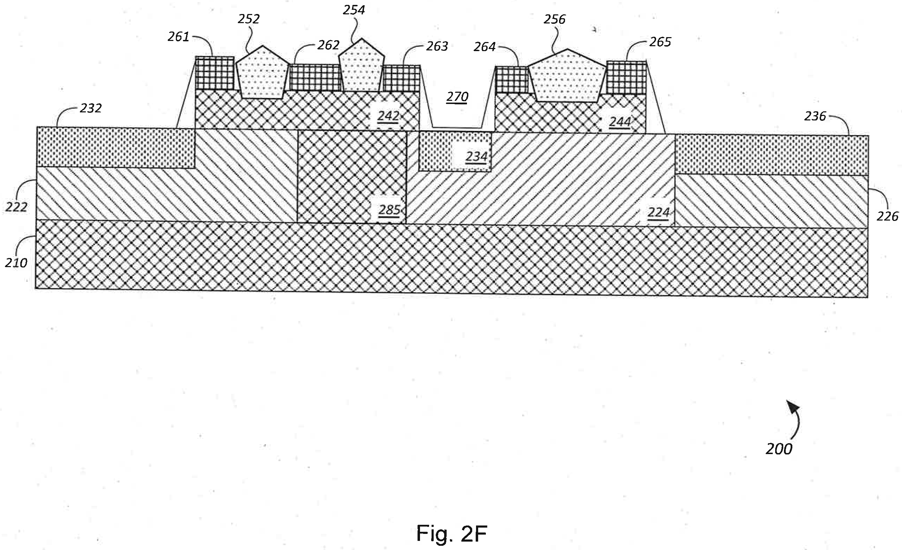

Figs. 2A-2F illustrate a second example semiconductor device 200 with a second gate structure. Figs. 2A and 2B illustrate a first set of embodiments comprising the second example semiconductor device 200, in which a native region 285 is inserted in a p-type well 222 and/or under a first gate 262; Figs. 2C-2D illustrate a second set of embodiments comprising the second example semiconductor device 200, in which a native region 285 is inserted in an n-type well 224 and/or under a second gate 263; and Figs. 2E-2F illustrate a third set of embodiments comprising the second example semiconductor device 200, in which a native region 285 is disposed in both a p-type well 222 and an n-type well 262 and 263. Other than the disposition of the native region 285, the semiconductor devices 200 illustrated by Figs. 2A-2F are substantially similar.

Referring to Fig. 2A, a top view illustrating the example semiconductor device 200 is shown, in accordance with some aspects of the disclosure. The semiconductor device 200 can be implemented as a variety of types of semiconductor devices, such as various different types and combinations of transistor structures. For example, the semiconductor device 200 can be a non-planar (three-dimensional) FinFET device such as, for example, an LDMOS device. As shown in Fig. 2A, the semiconductor device 200 includes an example channel 240. The channel 240 can be implemented in a variety of ways using a variety suitable materials and/or combinations of materials. For example, the channel 240 can include a conductive silicon fin in implementations where the semiconductor device 200 is a FinFET device. The channel 240 can also include any other suitable type of conductive fin or other channel-type structure used in the semiconductor device 200. The semiconductor device 200 is also shown to include a plurality of gates including a gate 262, a gate 262, a gate 263, a gate 264, and a gate 265. The semiconductor device 200 is further shown to include a source 252, an epitaxial layer 254, a drain 256, and a trench 270 formed in the channel 240 and between the gate 263 and the drain 256. The semiconductor device 200 is also shown to include an oxide diffusion layer 290 (e.g., a thick oxide layer, etc.) and a doped layer 280 (e.g., an N+ buried layer, a deep n-well layer, etc.).

Referring to Fig. 2B, a cross section view illustrating the example semiconductor device 200 is shown, in accordance with some aspects of the disclosure. The illustrated cross section of the semiconductor device 200 as shown in Fig. 2B can be taken along the line X' as shown in Fig. 2A, for example. In the cross section of the semiconductor device 200 as shown in Fig. 2B, the source 252, the epitaxial layer 254, the drain 256, the gate 262, the gate 262, the gate 263, the gate 264, and the gate 265 can all be seen. Additionally, the trench 270 can be seen, where the trench 270 is formed between two separate regions of the channel 240: a channel region 242 and a channel region 244. In the cross section of the semiconductor device 200 as shown in Fig. 2B, additional layers can also be seen, including a substrate 220, a p-type well 222, an n-type well 224, a p-type well 226, an isolation structure 232, an isolation structure 234, an isolation structure 236, and various oxide layers (e.g., gate oxide layers, etc.) formed around and/or between the source 252, the epitaxial layer 254, the drain 256, the gate 262, the gate 262, the gate 263, the gate 264, the gate 265, the channel region 242, and the channel region 244.

The substrate 220 can be formed of silicon material (e.g., crystalline silicon) and/or other suitable materials or combinations of materials. The substrate 220 can be implemented using various fabrication technologies, such as using an SOI structure, a bulk semiconductor structure, an alloy semiconductor, a compound semiconductor, germanium, and/or various other suitable materials and combinations thereof. The substrate 220 can generally provide a base for forming components of the semiconductor device 200 thereon. The semiconductor device 200 can be implemented in a variety of different types of circuits, inducing various types of IC chips built on various types of substrates.

The p-type well 222 and the p-type well 226 can be regions of the semiconductor device 200 that are doped using one or more suitable p-type dopants such as, for example, boron and/or other p-type dopants. The n-type well 224 can be a region of the semiconductor device 200 that is doped using one or more suitable n-type dopants such as arsenic, phosphorous, and/or other n-type dopants. The p-type well 222, the n-type well 224, and the p-type well 226 can be regions of the substrate 220 such that the p-type well 222, the n-type well 224, and the p-type well 226 include doped silicon material, for example. The p-type well 222, the n-type well 224, and the p-type well 226 can also be formed at least partially separate from the substrate 220. For example, the p-type well 222, the n-type well 224, and the p-type well 226 can be formed at least partially within various types of oxide layers and/or other insulating/dielectric layers of the semiconductor device 200. Notably, as shown in Fig. 2B, the isolation structure 234, the gate 263, and the trench 270 can be disposed over the n-type well 224. As a result of this structure, the region of the semiconductor device 200 between the gate 263 and the gate 264 can serve as a depletion region. The depletion region within the semiconductor device 200 can deplete charge carriers and thereby limit the amount of current that can flow through the depletion region, enabling the semiconductor device 200 to operate under higher voltage conditions. The doping polarities of the p-type well 222, the n-type well 224, and the p-type well 226 can be reversed in some applications (e.g., to provide a PLDMOS device instead of an LDMOS device).

The isolation structure 232, the isolation structure 234, and the isolation structure 236 can be STI structures, for example, among other possible types of dielectric layers. The isolation structure 232, the isolation structure 234, and the isolation structure 236 can be formed as a result of etching trenches in the semiconductor device 200. For example, after etching the trench 270 in the channel 240 and the n-type well 224, the isolation structure 234 can be formed by depositing a dielectric material at least partially within the trench 270. The dielectric material used to form the isolation structure 232, the isolation structure 234, and the isolation structure 236 can be, for example, silicon oxide, silicon nitride, and/or other suitable materials and combinations of materials. The isolation structure 232, the isolation structure 234, and the isolation structure 236 can prevent leakage of electric current between various components of the semiconductor device 200, for example.

The source 252 and the drain 256 can be implemented as epitaxial layers as part of the semiconductor device 200, along with the epitaxial layer 254. The source 252, the epitaxial layer 254, and the drain 256 can be formed using various types of epitaxy processes and a variety of suitable epitaxial materials. The epitaxial materials can include, for example, silicon, gallium arsenide, and/or other suitable epitaxial materials and combinations thereof. In some examples, the source 252, the epitaxial layer 254, and/or the drain 256 can be doped using suitable n-type or p-type dopants. Ultimately, the source 252 can be used to form a source terminal of a transistor (e.g., after forming a silicide layer and an interconnect on the epitaxial layer, etc.) and the drain 256 can then be used to form a drain terminal of a transistor (e.g., after forming a silicide layer and an interconnect on the epitaxial layer, etc.). The source 252 can be disposed on the channel 240 between the gate 262 and the gate 262, the epitaxial layer 254 can be disposed on the channel 240 between the gate 262 and the gate 263, and the drain 256 can be disposed on the channel 240 between the gate 264 and the gate 265. The source 252, the epitaxial layer 254, and/or the drain 256 can be disposed directly on the channel 240 or there can be some materials and/or layers between the source 252, the epitaxial layer 254, and/or the drain 256 and the channel 240.

In the semiconductor device 200, the gate 262 and the gate 263 can both be implemented as active gates such that the semiconductor device 200 is a multigate (split gate) device. That is, bias voltages that are applied at the gate 262 and the gate 263 can generally control operation and conductance of the semiconductor device 200. Then, in contrast, the gate 262, the gate 264, and the gate 265 can be implemented as "dummy" gates that are not active components of the semiconductor device 200, but can provide advantages in terms of the fabrication process for and the performance of the semiconductor device 200. The gate 262, the gate 264, and the gate 265 can be formed using polysilicon material and/or another suitable material or combination of materials.

The width of the gate 262 (as measured in the direction between the gate 262 and the gate 263 as shown in Fig. 2A) can be greater than the width of the gate 262, the width of the gate 264, and the width of the gate 265. Similarly, the width of the gate 263 (as measured in the direction between the gate 262 and the gate 264 as shown in Fig. 2A) can be greater than the width of the gate 262, the width of the gate 264, and the width of the gate 265. To provide advantages in terms of performance and durability, the width of the gate 262 and the width of the gate 263 can be between 50 nanometers and 360 nanometers, and the width of the gate 262, the width of the gate 264, and the width of the gate 265 can be between 50 nanometers and 200 nanometers. The gate 262, the gate 262, the gate 263, the gate 264, and the gate 265 can be disposed directly on the channel 240 or there can be some materials and/or layers between the gate 262, the gate 262, the gate 263, the gate 264, and the gate 265 and the channel 240 (e.g., gate oxide layers, etc.).

Relative to the semiconductor device 200, some alternate device structures may suffer from durability issues due to factors such as HCl degradation, for example, among other possible factors. The durability issues can cause the overall device performance to degrade over time, and the durability issues can become even more prevalent especially as process node sizes continue to decrease with improvements in semiconductor fabrication technology. Moreover, as a result of process limitations associated with semiconductor fabrication technology (e.g., limitations of semiconductor fabrication plants), some approaches to improving device durability such as, for example, increasing channel length may not be feasible in various applications. However, the specific structure of the semiconductor device 200 can provide advantages in terms of improved durability relative to some alternate structures.

Notably, in the semiconductor device 200, the gate 262 can include and/or can be formed using a first metal, whereas the gate 263 can include and/or can be formed using a second metal that is different from the first metal. The second metal can be different from the first metal such that the gate 262 has a first threshold voltage (V_{T2}) and the gate 263 has a second threshold voltage (V_{T2}), where the second threshold voltage is greater than the first threshold voltage. This variance of the first threshold voltage and the second threshold voltage can alter the current flow and electrical fields within the semiconductor device 200 when compared to some alternate device structures in a manner that improves the durability of the semiconductor device 200. The first threshold voltage and the second threshold voltage can be the threshold bias voltage levels required to be applied to the gate 262 and the gate 263, respectively, to transition the semiconductor device 200 from an off state to an on state (e.g., the voltage levels required for current to flow through the semiconductor device 200).

By increasing the second threshold voltage relative to the first threshold voltage, the durability of the semiconductor device 200 (especially under higher operating voltage conditions) can be improved by reducing the effects of HCl degradation and/or other undesirable degradation effects that may otherwise occur. The second threshold voltage can be altered using the second metal in a variety of suitable manners. For example, the gate 263 can include a work function metal (e.g., the second metal) that increases the second threshold voltage relative to the first threshold voltage. The gate 263 can also be formed using an entirely different metal than the gate 262 in some implementations. The first metal can include molybdenum nitride, molybdenum, aluminum, tungsten nitride, titanium nitride, or tantalum nitride, for example. The second metal likewise can include molybdenum nitride, molybdenum, aluminum, tungsten nitride, titanium nitride, or tantalum nitride, for example. Relative to the semiconductor device 200, the inclusion of the epitaxial layer 254 in the structure of the semiconductor device 200 can provide advantages in certain applications.

The semiconductor device 200 can also comprise one or more native regions 285. Exemplary locations and characteristics of a native region are described above with respect to the native regions 185 of the example semiconductor devices 100 illustrated by Figs. 1A-1F, and that discussion applies equally to the native regions 285 of the example semiconductor devices 200 of Figs. 2A-2F.

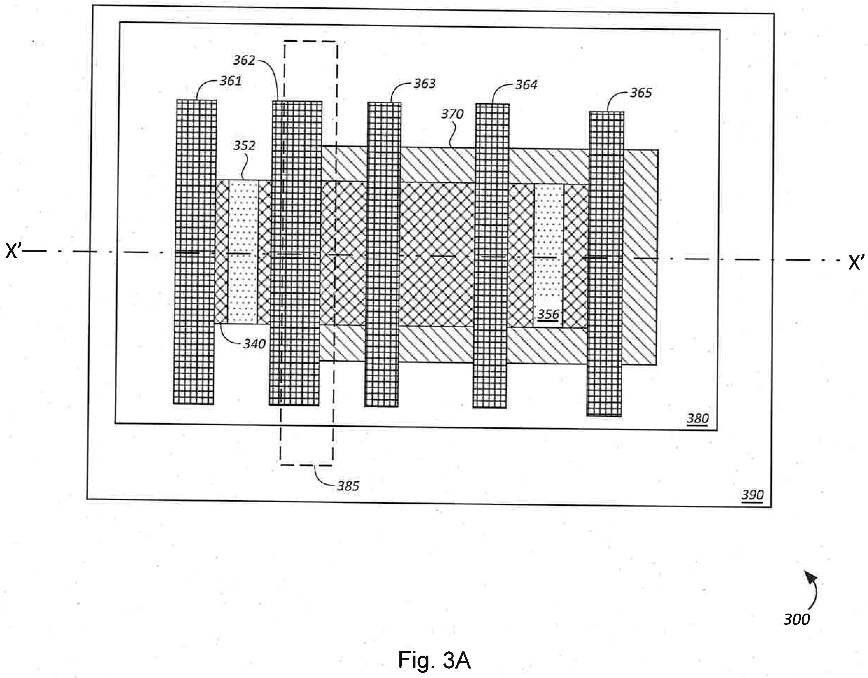

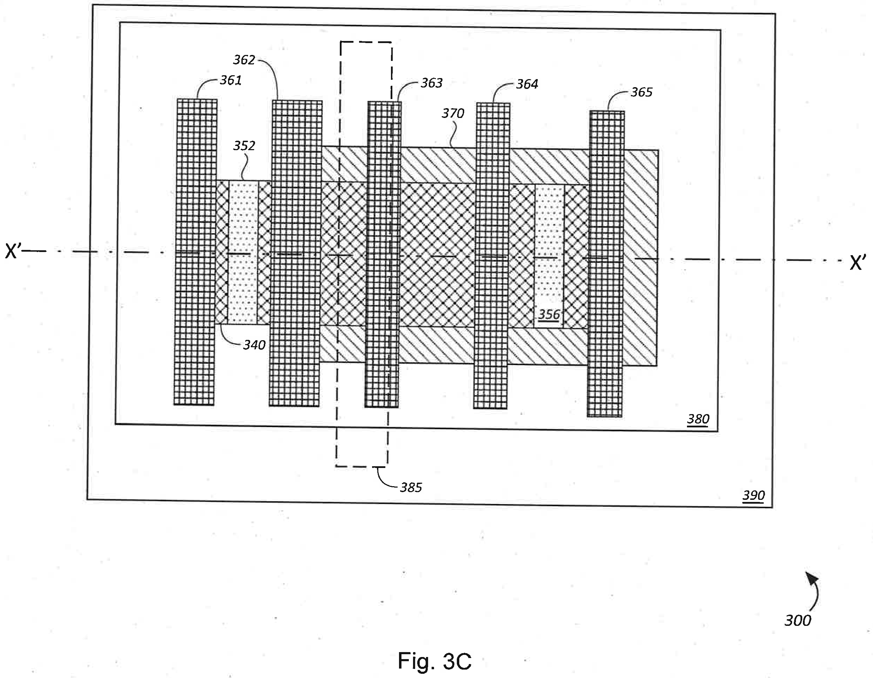

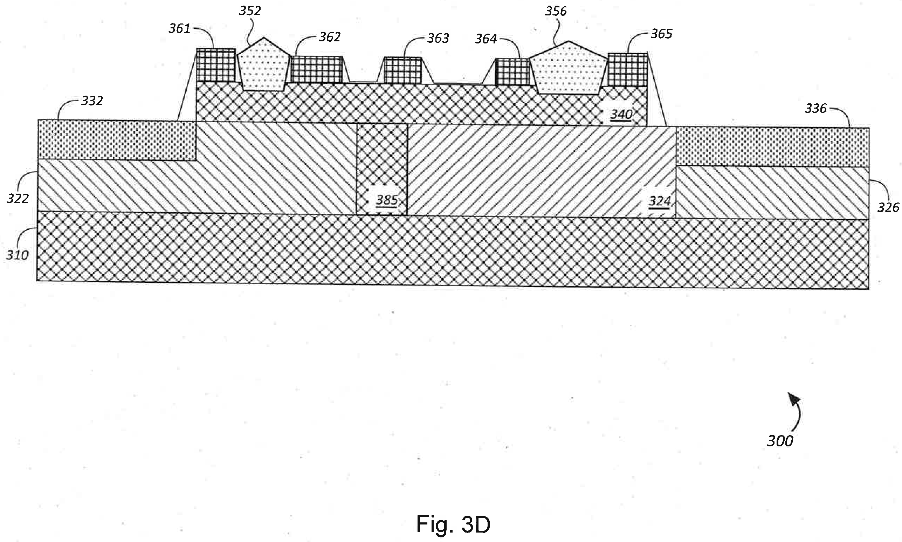

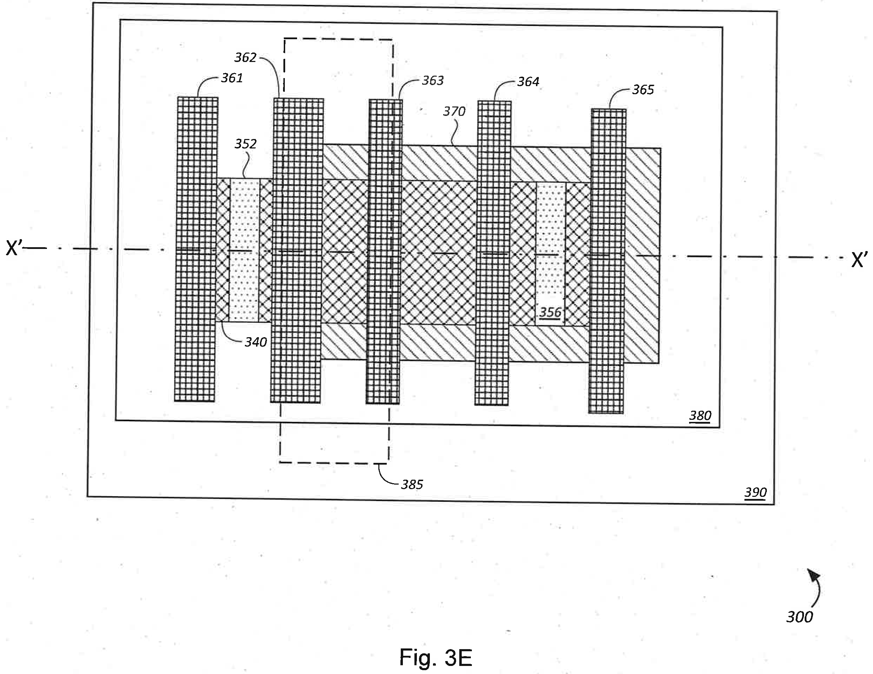

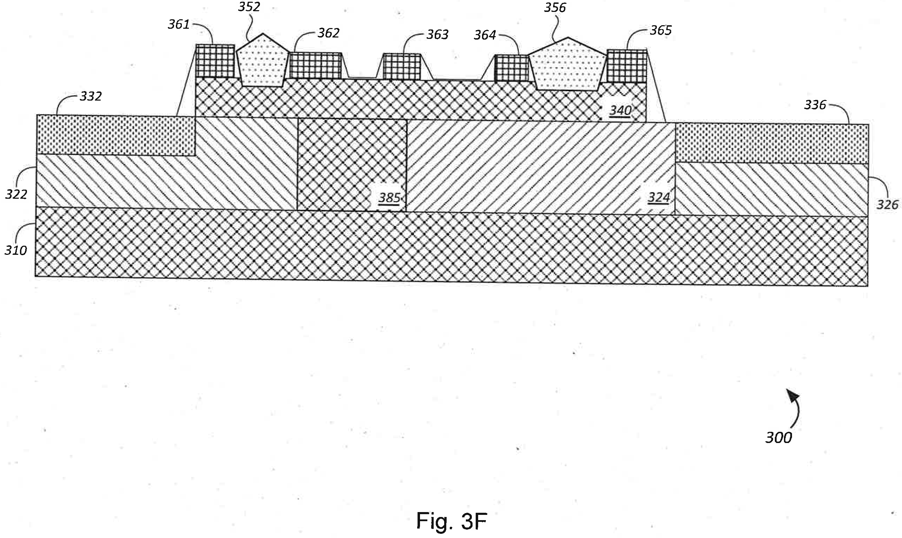

Figs. 3A-3F illustrate a third example semiconductor device 300 with a third gate structure. Figs. 3A-3B illustrate a first set of embodiments comprising the third example semiconductor device 300, in which a native region 385 is inserted in a p-type well 322 and/or under a first gate 362; Figs. 3C-3D illustrate a second set of embodiments comprising the third example semiconductor device 300, in which a native region 385 is inserted in an n-type well 324 and/or under a second gate 363; and Figs. 3E-3F illustrate a third set of embodiments comprising the third example semiconductor device 300, in which a native region 385 is disposed in both a p-type well 322 and an n-type well 324 and/or under both the first gate 362 and the second gate 364. Other than the disposition of the native region 385, the semiconductor devices 300 illustrated by Figs. 3A-3F are substantially similar.

Referring to Fig. 3A, a top view illustrating the example semiconductor device 300 is shown, in accordance with some aspects of the disclosure. The semiconductor device 300 can be implemented as a variety of types of semiconductor devices, such as various different types and combinations of transistor structures. For example, the semiconductor device 200 can be a non-planar (three-dimensional) FinFET device such as, for example, an LDMOS device. As shown in Fig. 3A, the semiconductor device 200 includes an example channel 340. The channel 340 can be implemented in a variety of ways using a variety suitable materials and/or combinations of materials. For example, the channel 340 can include a conductive silicon fin in implementations where the semiconductor device 300 is a FinFET device. The channel 340 can also include any other suitable type of conductive fin or other channel-type structure used in the semiconductor device 300. The semiconductor device 300 is also shown to include a plurality of gates including a gate 362, a gate 362, a gate 363, a gate 364, and a gate 365. The semiconductor device 300 is further shown to include a source 352, a drain 354, an oxide diffusion layer 390 (e.g., a thick oxide layer, etc.), and a doped layer 380 (e.g., an N+ buried layer, a deep n-well layer, etc.).

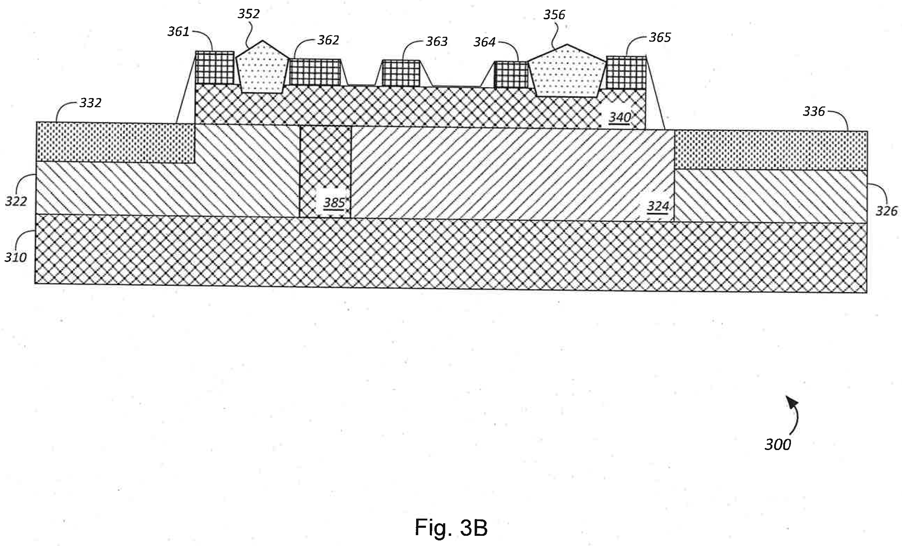

Referring to Fig. 3B, a cross section view illustrating the example semiconductor device 300 is shown, in accordance with some aspects of the disclosure. The illustrated cross section of the semiconductor device 300 as shown in Fig. 3B can be taken along the line X' as shown in Fig. 3A, for example. In the cross section of the semiconductor device 300 as shown in Fig. 3B, the source 352, the drain 354, the gate 362, the gate 362, the gate 363, the gate 364, the gate 365, and the channel 340 can all be seen. In the cross section of the semiconductor device 300 as shown in Fig. 3B, additional layers can also be seen, including a substrate 320, a p-type well 322, an n-type well 324, a p-type well 326, an isolation structure 332, an isolation structure 334, and various oxide layers (e.g., gate oxide layers, etc.) formed around and/or between the source 352, the drain 354, the gate 362, the gate 362, the gate 363, the gate 364, the gate 365, and the channel 340.

The substrate 320 can be formed of silicon material (e.g., crystalline silicon) and/or other suitable materials or combinations of materials. The substrate 320 can be implemented using various fabrication technologies, such as using an SOI structure, a bulk semiconductor structure, an alloy semiconductor, a compound semiconductor, germanium, and/or various other suitable materials and combinations thereof. The substrate 320 can generally provide a base for forming components of the semiconductor device 300 thereon. The semiconductor device 300 can be implemented in a variety of different types of circuits, inducing various types of IC chips built on various types of substrates.

The p-type well 322 and the p-type well 326 can be regions of the semiconductor device 300 that are doped using one or more suitable p-type dopants such as, for example, boron and/or other p-type dopants. The n-type well 324 can be a region of the semiconductor device 300 that is doped using one or more suitable n-type dopants such as arsenic, phosphorous, and/or other n-type dopants. The p-type well 322, the n-type well 324, and the p-type well 326 can be regions of the substrate 320 such that the p-type well 322, the n-type well 324, and the p-type well 326 include doped silicon material, for example. The p-type well 322, the n-type well 324, and the p-type well 326 can also be formed at least partially separate from the substrate 320. For example, the p-type well 322, the n-type well 324, and the p-type well 326 can be formed at least partially within various types of oxide layers and/or other insulating/dielectric layers of the semiconductor device 300. Notably, as shown in Fig. 3B, the gate 363 can be disposed over the n-type well 324. As a result of this structure, the region of the semiconductor device 300 between the gate 363 and the gate 364 can serve as a depletion region. The depletion region within the semiconductor device 300 can deplete charge carriers and thereby limit the amount of current that can flow through the depletion region, enabling the semiconductor device 300 to operate under higher voltage conditions. The doping polarities of the p-type well 322, the n-type well 324, and the p-type well 326 can be reversed in some applications (e.g., to provide a PLDMOS device instead of an LDMOS device).

The isolation structure 332 and the isolation structure 334 can be implemented as STI structures, for example, among other possible types of dielectric layers. The isolation structure 332 and the isolation structure 334 can be formed by etching trenches in the semiconductor device 300. For example, after etching a trench in the p-type well 322, the isolation structure 332 can be formed by depositing a dielectric material at least partially within the trench. The dielectric material used to form the isolation structure 332 and the isolation structure 334 can be, for example, silicon oxide, silicon nitride, and/or other suitable materials and combinations of materials. The isolation structure 332 and the isolation structure 334 can prevent leakage of electric current between various components of the semiconductor device 300, for example.

The source 352 and the drain 354 can be implemented as epitaxial layers as part of the semiconductor device 300. For example, the source 352 and the drain 354 can be formed using various types of epitaxy processes and a variety of suitable epitaxial materials. The epitaxial materials can include, for example, silicon, gallium arsenide, and/or other suitable epitaxial materials and combinations thereof. In some examples, the source 352 and/or the drain 354 can be doped using suitable n-type or p-type dopants. Ultimately, the source 352 can be used to form a source terminal of a transistor (e.g., after forming a silicide layer and an interconnect on the epitaxial layer, etc.) and the drain 354 can be used to form a drain terminal of a transistor (e.g., after forming a silicide layer and an interconnect on the epitaxial layer, etc.). The source 352 can be disposed on the channel 340 between the gate 362 and the gate 362, and the drain 354 can be disposed on the channel 340 between the gate 364 and the gate 365. The source 352 and/or the drain 354 can be disposed directly on the channel 340 or there can be some materials and/or layers between the source 352 and/or the drain 354 and the channel 340.

In the semiconductor device 200, the gate 362 and the gate 363 can both be implemented as active gates such that the semiconductor device 300 is a multigate (split gate) device. That is, bias voltages that are applied at the gate 362 and the gate 363 can generally control operation and conductance of the semiconductor device 300. Then, in contrast, the gate 362, the gate 234, and the gate 365 can be implemented as "dummy" gates that are not active components of the semiconductor device 300, but can provide advantages in terms of the fabrication process for and the performance of the semiconductor device 300. The gate 362, the gate 364, and the gate 365 can be formed using polysilicon material and/or another suitable material or combination of materials.

The width of the gate 362 (as measured in the direction between the gate 362 and the gate 363 as shown in Fig. 3A) can be greater than the width of the gate 362, the width of the gate 364, and the width of the gate 365. Similarly, the width of the gate 363 (as measured in the direction between the gate 362 and the gate 364 as shown in Fig. 3A) can be greater than the width of the gate 362, the width of the gate 364, and the width of the gate 365. To provide advantages in terms of performance and durability, the width of the gate 362 and the width of the gate 363 can be between 50 nanometers and 360 nanometers, and the width of the gate 362, the width of the gate 364, and the width of the gate 365 can be between 50 nanometers and 200 nanometers. The gate 362, the gate 362, the gate 363, the gate 364, and the gate 365 can be disposed directly on the channel 340 or there can be some materials and/or layers between the gate 362, the gate 362, the gate 363, the gate 364, and the gate 365 and the channel 340 (e.g., gate oxide layers, etc.).

Relative to the semiconductor device 300, some alternate device structures may suffer from durability issues due to factors such as HCl degradation, for example, among other possible factors. The durability issues can cause the overall device performance to degrade over time, and the durability issues can become even more prevalent especially as process node sizes continue to decrease with improvements in semiconductor fabrication technology. Moreover, as a result of process limitations associated with semiconductor fabrication technology (e.g., limitations of semiconductor fabrication plants), some approaches to improving device durability such as, for example, increasing channel length may not be feasible in various applications. However, the specific structure of the semiconductor device 300 can provide advantages in terms of improved durability relative to some alternate structures.

Notably, in the semiconductor device 300, the gate 362 can include and/or can be formed using a first metal, whereas the gate 363 can include and/or can be formed using a second metal that is different from the first metal. The second metal can be different from the first metal such that the gate 362 has a first threshold voltage (V_{T2}) and the gate 363 has a second threshold voltage (V_{T2}), where the second threshold voltage is greater than the first threshold voltage. This variance of the first threshold voltage and the second threshold voltage can alter the current flow and electrical fields within the semiconductor device 300 when compared to some alternate device structures in a manner that improves the durability of the semiconductor device 300. The first threshold voltage and the second threshold voltage can be the threshold bias voltage levels required to be applied to the gate 362 and the gate 363, respectively, to transition the semiconductor device 300 from an off state to an on state (e.g., the voltage levels required for current to flow through the semiconductor device 300).

By increasing the second threshold voltage relative to the first threshold voltage, the durability of the semiconductor device 300 (especially under higher operating voltage conditions) can be improved by reducing the effects of HCl degradation and/or other undesirable degradation effects that may otherwise occur. The second threshold voltage can be altered using the second metal in a variety of suitable manners. For example, the gate 363 can include a work function metal (e.g., the second metal) that increases the second threshold voltage relative to the first threshold voltage. The gate 363 can also be formed using an entirely different metal than the gate 362 in some implementations. The first metal can include molybdenum nitride, molybdenum, aluminum, tungsten nitride, titanium nitride, or tantalum nitride, for example. The second metal likewise can include molybdenum nitride, molybdenum, aluminum, tungsten nitride, titanium nitride, or tantalum nitride, for example. Relative to the semiconductor device 200, the absence of a trench and an isolation structure like the trench 270 and the isolation structure 234 in the structure of the semiconductor device 300 can provide advantages in certain applications.

The semiconductor device 300 can also comprise one or more native regions 385. Exemplary locations and characteristics of a native region are described above with respect to the native regions 185 of the example semiconductor devices 100 illustrated by Figs. 1A-1F, and that discussion applies equally to the native regions 385 of the example semiconductor devices 300 of Figs. 3A-3F.

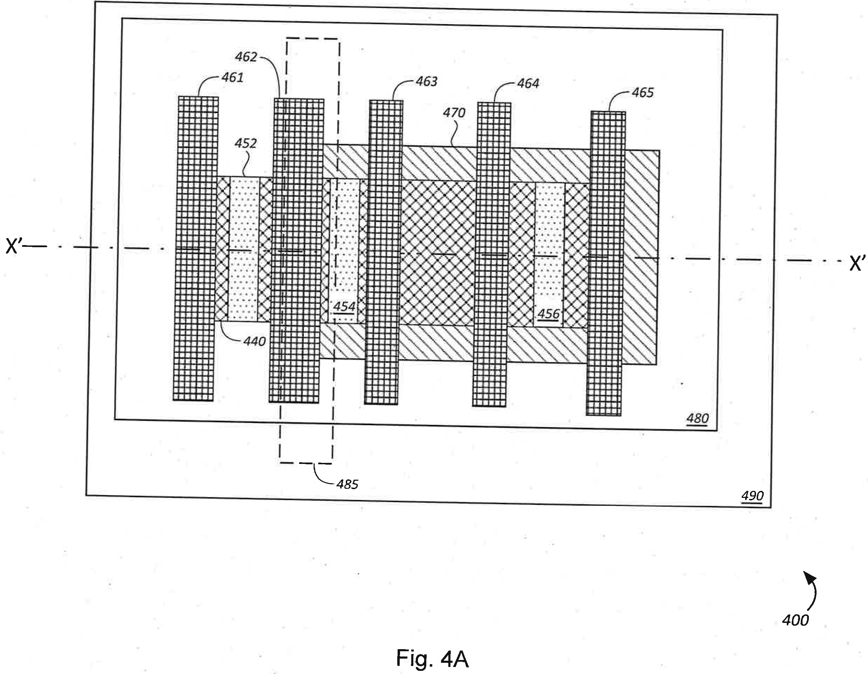

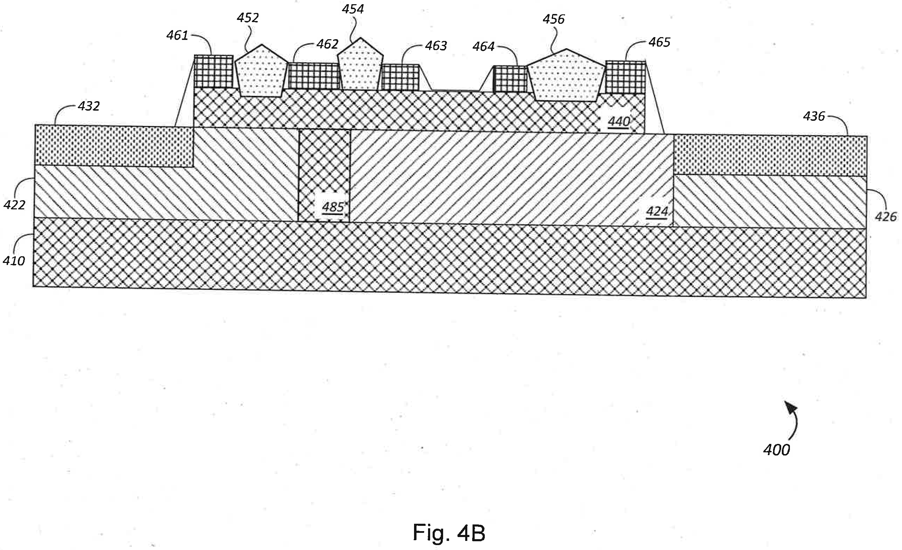

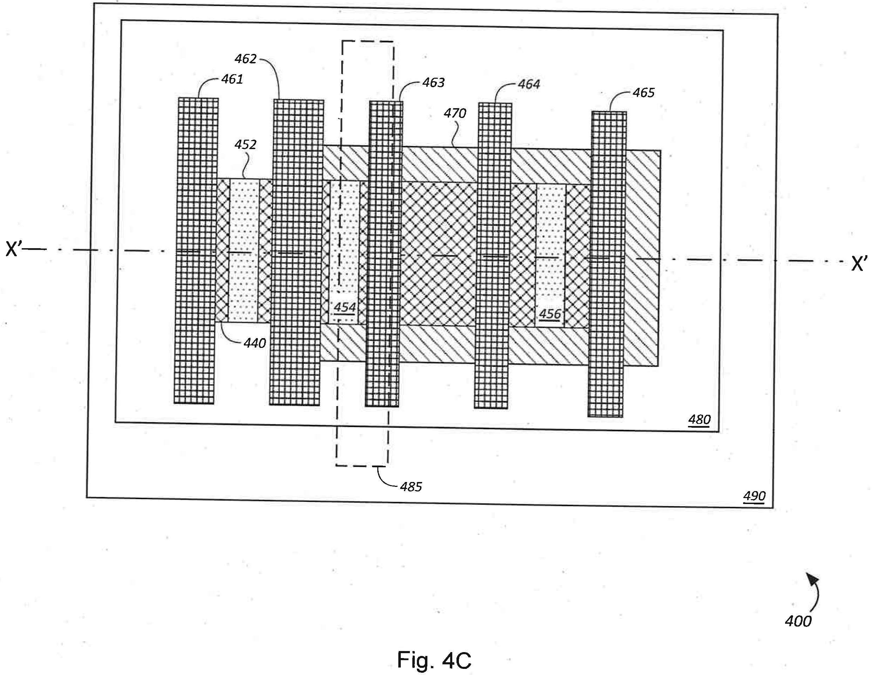

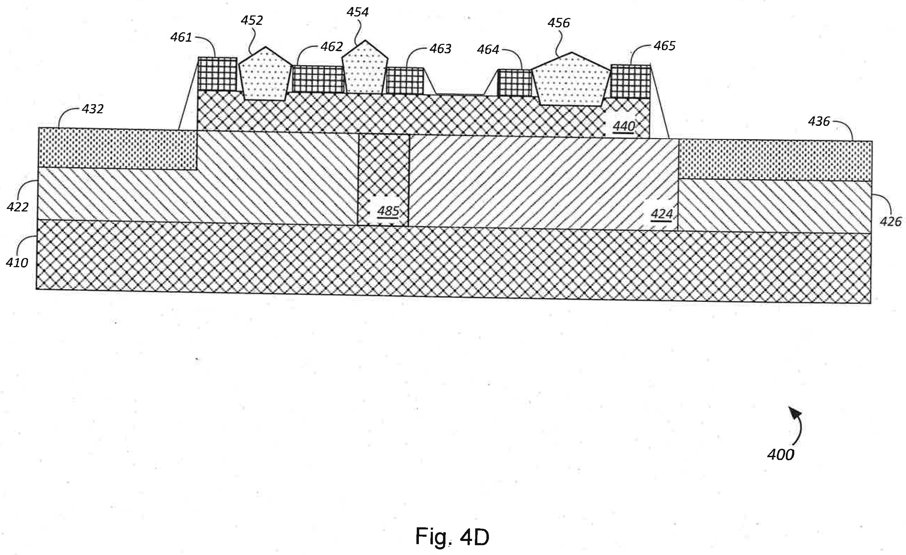

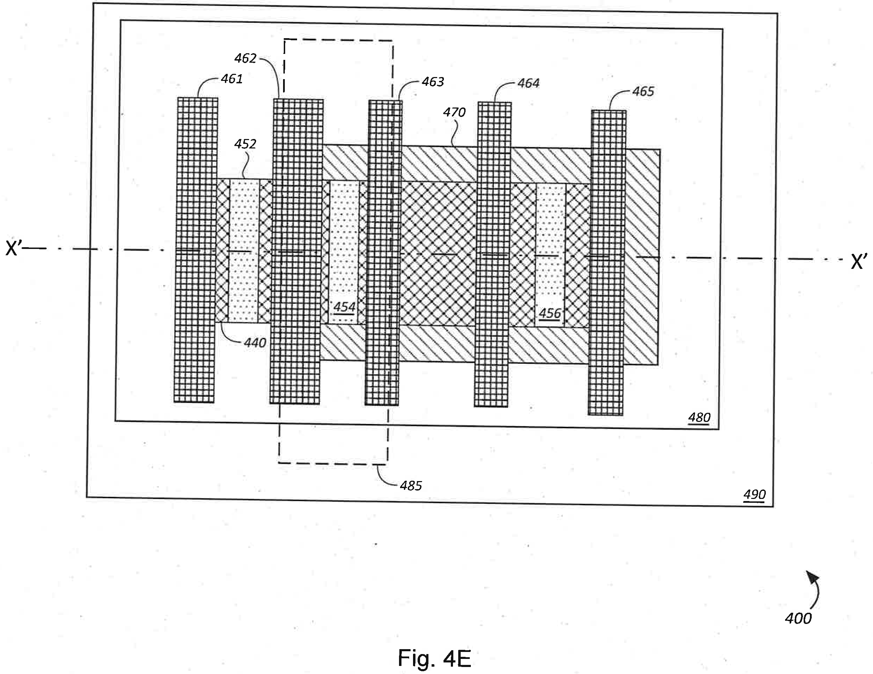

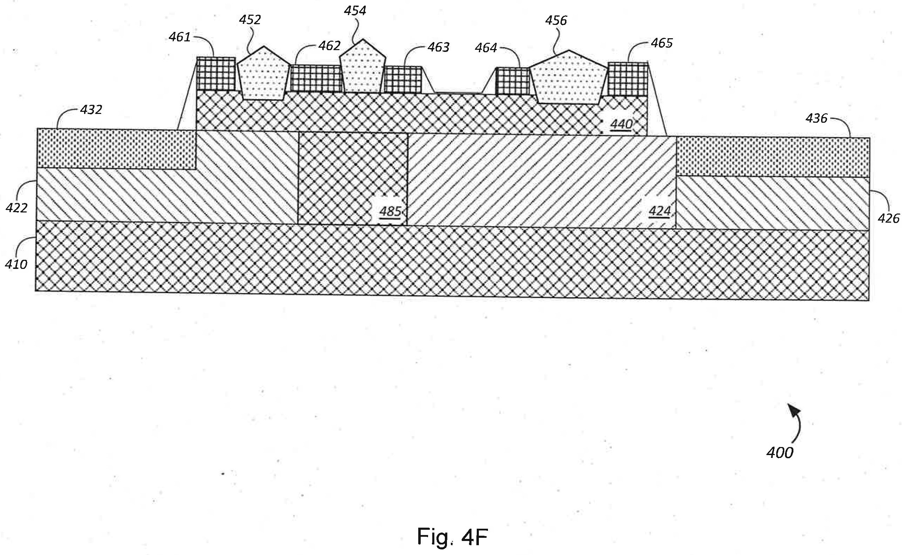

Figs. 4A-4F illustrate a fourth example semiconductor device 400 with a fourth gate structure. Figs. 4A and 4B illustrate a first set of embodiments comprising the fourth example semiconductor device 400, in which a native region 485 is inserted in a p-type well 422 and/or under a first gate 462; Figs. 4C-4D illustrate a second set of embodiments comprising the fourth example semiconductor device 400, in which a native region 485 is inserted in an n-type well 424 and/or under a second gate 463; and Figs. 4E-4F illustrate a third set of embodiments comprising the fourth example semiconductor device 400, in which a native region 485 is disposed in both a p-type well 422 and an n-type well 424 and/or under the first gate 462 and the second gate 463. Other than the disposition of the native region 485, the semiconductor devices 400 illustrated by Figs. 4A-4F are substantially similar.

Referring to Fig. 4A, a top view illustrating the example semiconductor device 400 is shown, in accordance with some aspects of the disclosure. The semiconductor device 400 can be implemented as a variety of types of semiconductor devices, such as various different types and combinations of transistor structures. For example, the semiconductor device 400 can be a non-planar (three-dimensional) FinFET device such as, for example, an LDMOS device. As shown in Fig. 4A, the semiconductor device 400 includes an example channel 440. The channel 440 can be implemented in a variety of ways using a variety suitable materials and/or combinations of materials. For example, . the channel 440 can include a conductive silicon fin in implementations where the semiconductor device 400 is a FinFET device. The channel 440 can also include any other suitable type of conductive fin or other channel-type structure used in the semiconductor device 400. The semiconductor device 400 is also shown to include a plurality of gates including a gate 462, a gate 462, a gate 463, a gate 464, and a gate 465. The semiconductor device 400 is further shown to include a source 452, an epitaxial layer 454, a drain 456, an oxide diffusion layer 490 (e.g., a thick oxide layer, etc.), and a doped layer 480 (e.g., an N+ buried layer, a deep n-well layer, etc.).

Referring to Fig. 4B, a cross section view illustrating the example semiconductor device 400 is shown, in accordance with some aspects of the disclosure. The illustrated cross section of the semiconductor device 400 as shown in Fig. 4B can be taken along the line X' as shown in Fig. 4A, for example. In the cross section of the semiconductor device 400 as shown in Fig. 4B, the source 452, the epitaxial layer 454, the drain 456, the gate 462, the gate 462, the gate 463, the gate 464, the gate 465, and finally the channel 440 can all be seen. In the cross section of the semiconductor device 400 as shown in Fig. 4B, additional layers can also be seen, including a substrate 420, a p-type well 422, an n-type well 424, a p-type well 426, an isolation structure 432, an isolation structure 434, and various oxide layers (e.g., gate oxide layers, etc.) formed around and/or between the source 452, the epitaxial layer 454, the drain 456, the gate 462, the gate 462, the gate 463, the gate 464, the gate 465, and the channel 440.

The substrate 420 can be formed of silicon material (e.g., crystalline silicon) and/or other suitable materials or combinations of materials. The substrate 420 can be implemented using various fabrication technologies, such as using an SOI structure, a bulk semiconductor structure, an alloy semiconductor, a compound semiconductor, germanium, and/or various other suitable materials and combinations thereof. The substrate 420 can generally provide a base for forming components of the semiconductor device 400 thereon. The semiconductor device 400 can be implemented in a variety of different types of circuits, inducing various types of IC chips built on various types of substrates.

The p-type well 422 and the p-type well 426 can be regions of the semiconductor . device 400 that are doped using one or more suitable p-type dopants such as, for example, boron and/or other p-type dopants. The n-type well 424 can be a region of the semiconductor device 400 that is doped using one or more suitable n-type dopants such as arsenic, phosphorous, and/or other n-type dopants. The p-type well 422, the n-type well 424, and the p-type well 426 can be regions of the substrate 420 such that the p-type well 422, the n-type well 424, and the p-type well 426 include doped silicon material, for example. The p-type well 422, the n-type well 424, and the p-type well 426 can also be formed at least partially separate from the substrate 420. For example, the p-type well 422, the n-type well 424, and the p-type well 426 can be formed at least partially within various types of oxide layers and/or other insulating/dielectric layers of the semiconductor device 400. Notably, as shown in Fig. 4B, the gate 463 can be disposed over the n-type well 424. As a result of this structure, the region of the semiconductor device 400 between the gate 463 and the gate 464 can serve as a depletion region. The depletion region within the semiconductor device 400 can deplete charge carriers and thereby limit the amount of current that can flow through the depletion region as well as enable the semiconductor device 400 to operate under higher voltage conditions. The doping polarities of the p-type well 422, the n-type well 424, and the p-type well 426 can be reversed in some applications (e.g., to provide a PLDMOS device instead of an LDMOS device).

The isolation structure 432 and the isolation structure 434 can be implemented as STI structures, for example, among other possible types of dielectric layers. The isolation structure 432 and the isolation structure 434 can be formed by etching trenches in the semiconductor device 400. For example, after etching a trench in the p-type well 422, the isolation structure 432 can be formed by depositing a dielectric material at least partially within the trench. The dielectric material used to form the isolation structure 432 and the isolation structure 434 can be, for example, silicon oxide, silicon nitride, and/or other suitable materials and combinations of materials. The isolation structure 432 and the isolation structure 434 can prevent leakage of electric current between various components of the semiconductor device 400, for example.

The source 452 and the drain 456 can be implemented as epitaxial layers as part of the semiconductor device 400, along with the epitaxial layer 454. The source 452, the epitaxial layer 454, and the drain 456 can be formed using various types of epitaxy processes and a variety of suitable epitaxial materials. The epitaxial materials can include, for example, silicon, gallium arsenide, and/or other suitable epitaxial materials and combinations thereof. In some examples, the source 452, the epitaxial layer 454, and/or the drain 456 can be doped using suitable n-type or p-type dopants. Ultimately, the source 452 can be used to form a source terminal of a transistor (e.g., after forming a silicide layer and an interconnect on the epitaxial layer, etc.) and the drain 456 can then be used to form a drain terminal of a transistor (e.g., after forming a silicide layer and an interconnect on the epitaxial layer, etc.). The source 452 can be disposed on the channel 440 between the gate 462 and the gate 462, the epitaxial layer 454 can be disposed on the channel 440 between the gate 462 and the gate 463, and the drain 456 can be disposed on the channel 440 between the gate 464 and the gate 465. The source 452, the epitaxial layer 454, and/or the drain 456 can be disposed directly on the channel 440 or there can be some materials and/or layers between the source 452, the epitaxial layer 454, and/or the drain 456 and the channel 440.

In the semiconductor device 400, the gate 462 and the gate 463 can both be implemented as active gates such that the semiconductor device 400 is a multigate (split gate) device. That is, bias voltages that are applied at the gate 462 and the gate 463 can generally control operation and conductance of the semiconductor device 400. Then, in contrast, the gate 462, the gate 464, and the gate 465 can be implemented as "dummy" gates that are not active components of the semiconductor device 400, but can provide advantages in terms of the fabrication process for and the performance of the semiconductor device 400. The gate 462, the gate 464, and the gate 465 can be formed using polysilicon material and/or another suitable material or combination of materials.

The width of the gate 462 (as measured in the direction between the gate 462 and the gate 463 as shown in Fig. 4A) can be greater than the width of the gate 462, the width of the gate 464, and the width of the gate 465. Similarly, the width of the gate 463 (as measured in the direction between the gate 462 and the gate 464 as shown in Fig. 4A) can be greater than the width of the gate 462, the width of the gate 464, and the width of the gate 465. To provide advantages in terms of performance and durability, the width of the gate 462 and the width of the gate 463 can be between 50 nanometers and 360 nanometers, and the width of the gate 462, the width of the gate 464, and the width of the gate 465 can be between 50 nanometers and 200 nanometers. The gate 462, the gate 462, the gate 463, the gate 464, and the gate 465 can be disposed directly on the channel4240 or there can be some materials and/or layers between the gate 462, the gate 462, the gate 463, the gate 464, and the gate 465 and the channel 440 (e.g., gate oxide layers, etc.).

Relative to the semiconductor device 400, some alternate device structures may suffer from durability issues due to factors such as HCl degradation, for example, among other possible factors. The durability issues can cause the overall device performance to degrade over time, and the durability issues can become even more prevalent especially as process node sizes continue to decrease with improvements in semiconductor fabrication technology. Moreover, as a result of process limitations associated with semiconductor fabrication technology (e.g., limitations of semiconductor fabrication plants), some approaches to improving device durability such as, for example, increasing channel length may not be feasible in various applications. However, the specific structure of the semiconductor device 400 can provide advantages in terms of improved durability relative to some alternate structures.

Notably in the semiconductor device 400, the gate 462 can include and/or can be formed using a first metal, whereas the gate 463 can include and/or can be formed using a second metal that is different from the first metal. The second metal can be different from the first metal such that the gate 462 has a first threshold voltage (V_{T2}) and the gate 463 has a second threshold voltage (V_{T2}), where the second threshold voltage is greater than the first threshold voltage. This variance of the first threshold voltage and the second threshold voltage can alter the current flow and electrical fields within the semiconductor device 400 when compared to some alternate device structures in a manner that improves the durability of the semiconductor device 400. The first threshold voltage and the second threshold voltage can be the threshold bias voltage levels required to be applied to the gate 462 and the gate 463, respectively, to transition the semiconductor device 400 from an off state to an on state (e.g., the voltage levels required for current to flow through the semiconductor device 400):

By increasing the second threshold voltage relative to the first threshold voltage, the durability of the semiconductor device 400 (especially under higher operating voltage conditions) can be improved by reducing the effects of HCl degradation and/or other undesirable degradation effects that may otherwise occur. The second threshold voltage can be altered using the second metal in a variety of suitable manners. For example, the gate 463 can include a work function metal (e.g., the second metal) that increases the second threshold voltage relative to the first threshold voltage. The gate 463 can also be formed using an entirely different metal than the gate 462 in some implementations. The first metal can include molybdenum nitride, molybdenum, aluminum, tungsten nitride, titanium nitride, or tantalum nitride, for example. The second metal likewise can include molybdenum nitride, molybdenum, aluminum, tungsten nitride, titanium nitride, or tantalum nitride, for example. Relative to the semiconductor device 200, the inclusion of the epitaxial layer 454 and the absence of a trench and an isolation structure like the trench 270 and the isolation structure 234 in the structure of the semiconductor device 400 can provide advantages in certain applications.

The semiconductor device 400 can also comprise one or more native regions 485. Exemplary locations and characteristics of a native region are described above with respect to the native regions 185 of the example semiconductor devices 100 illustrated by Figs. 1A-1F, and that discussion applies equally to the native regions 485 of the example semiconductor devices 400 of Figs. 4A-4F.

### Exemplary Embodiments

Certain exemplary embodiments are described below. Each of the described embodiments can be implemented separately or in any combination, as would be appreciated by one skilled in the art. Thus, no single embodiment or combination of embodiments should be considered limiting.

### Further Examples

The following examples described various features of certain embodiments. All such features of each example described below can be combined in any fashion, and different embodiments thus can include any set or subset of the features described below, as well as various features of the embodiments described above. No particular feature or set of features should be considered required by all embodiments. Conversely, some embodiments can combine some or all of these features in any manner understood, in light of this disclosure, by a skilled artisan.

Some embodiments provide semiconductor devices. An exemplary semiconductor device in accordance with some embodiments comprises a channel. In some embodiments, the semiconductor device comprises a source disposed on the channel. In some embodiments, the semiconductor device comprises a drain disposed on the channel. In some embodiments, the semiconductor device comprises a first gate. In some embodiments, the first gate comprises a first metal disposed on the channel between the source and the drain. In some embodiments, the semiconductor device comprises a second gate. In some embodiments, the second gate comprises a second metal disposed on the channel between the first gate and the drain. In some embodiments, the second metal is different from the first metal.

In some embodiments, the semiconductor device comprises a native region disposed below at least a portion of the channel. In some embodiments, the semiconductor device comprises a p-type well. In some embodiments, the semiconductor device comprises an n-type well.

In some embodiments, the native region is disposed within the p-type well and/or displaces at least a portion of the p-type well. In some embodiments, the native region is disposed within the p-type well and/or displaces at least a portion of the n-type well. In some embodiments, a first portion of the native region is disposed within the p-type well and/or displaces at least a portion of the p-type well. In some embodiments, a second portion of the native region is disposed within the n-type well and/or displaces at least a portion of the n-type well. In some embodiments, the native region separates the p-type well from the n-type well. In some embodiments, the native region shares a layer with the p-type well and/or the n-type well and is more lightly than the p-type well and/or the n-type well.

In some embodiments, the native region is disposed at least partially beneath the first gate. In some embodiments, the native region is disposed at least partially beneath the second gate. In some embodiments, the native region is disposed at least partially beneath the first gate and the second gate.

In some embodiments, the semiconductor device comprises comprising a substrate. In some embodiments, the native region and the substrate are doped at approximately the same level. In some embodiments, wherein the native region is contiguous with the substrate. In some embodiments, the native region is in direct contact with the channel.

In some embodiments, the second metal is different from the first metal. In some embodiments, the first gate has a first threshold voltage and the second gate has a second threshold voltage. In some embodiments, the second threshold voltage being greater than the first threshold voltage.

In some embodiments, the first gate comprises a first active gate. In some embodiments, the second gate comprises a second active gate. In some embodiments, the semiconductor device comprises a dummy gate disposed on the channel between the second gate and the drain.

An exemplary semiconductor device in accordance with some embodiments comprises a substrate. In some embodiments, the semiconductor device comprises a channel. In some embodiments, the semiconductor device comprises a p-type well. In some embodiments, the semiconductor device comprises an n-type well. In some embodiments, the semiconductor device comprises a source disposed on the channel. In some embodiments, the semiconductor device comprises a drain disposed on the channel. In some embodiments, the semiconductor device comprises a first gate. In some embodiments, the first gate comprises a first metal. In some embodiments, the first gate is disposed on the channel between the source and the drain. In some embodiments, the semiconductor device comprises a second gate. In some embodiments, the second gate comprises a second metal. In some embodiments, the second gate is disposed on the channel between the first gate and the drain. In some embodiments, the second metal is different from the first metal. In some embodiments, the semiconductor device comprises a native region.

In some embodiments, the native region is disposed within the p-type well. In some embodiments, the native region displaces at least a portion of the p-type well. In some embodiments, the native region is disposed within the p-type well. In some embodiments, the native region displaces at least a portion of the n-type well. In some embodiments, the native region is disposed under at least a portion of the first gate and at least a portion of the second gate. In some embodiments, a first portion of the native region is disposed within the p-type well and/or displaces at least a portion of the p-type well. In some embodiments, a second portion of the native region is disposed within the n-type well and/or displaces at least a portion of the n-type well.

An exemplary semiconductor device in accordance with some embodiments comprises a substrate. In some embodiments, the semiconductor device comprises a channel. In some embodiments, the semiconductor device comprises a source disposed on the channel. In some embodiments, the semiconductor device comprises a drain disposed on the channel. In some embodiments, the semiconductor device comprises a first gate. In some embodiments, the first gate comprises a first metal. In some embodiments, the first gate is disposed on the channel between the source and the drain. In some embodiments, the semiconductor device comprises a second gate. In some embodiments, the second gate comprises a second metal. In some embodiments, the second gate is disposed on the channel between the first gate and the drain. In some embodiments, the second metal is different from the first metal. In some embodiments, the semiconductor device comprises a native region. In some embodiments, the native region is contiguous with the substrate. In some embodiments, the native region is in direct contact with at least a portion of the channel

### Conclusion

In the foregoing description, for the purposes of explanation, numerous details are set forth to provide a thorough understanding of the described embodiments. It will be apparent to one skilled in the art, however, that other embodiments may be practiced without some of these details. In other instances, structures and devices are shown in block diagram form without full detail for the sake of clarity. Several embodiments are described herein, and while various features are ascribed to different embodiments, it should be appreciated that the features described with respect to one embodiment may be incorporated with other embodiments as well. By the same token, however, no single feature or features of any described embodiment should be considered essential to every embodiment of the invention, as other embodiments of the invention may omit such features. Thus, one skilled in the art will recognize that modifications may be made in light of the above disclosure or may be acquired from practice of the implementations, all of which can fall within the scope of various embodiments.

In this disclosure, when an element is referred to herein as being "connected" or "coupled" to another element, it is to be understood that one element can be directly connected to the other element or have intervening elements present between the elements. In contrast, when an element is referred to as being "directly connected" or "directly coupled" to another element, it should be understood that no intervening elements are present in the "direct" connection between the elements. However, the existence of a direct connection does not preclude other connections, in which intervening elements may be present.

When an element is referred to herein as being "disposed" in some manner relative to another element *(e.g.,* disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Likewise, when an element is referred to herein as being a "layer", it is to be understood that the layer can be a single layer or include multiple layers. For example, a conductive layer can include multiple different conductive materials or multiple layers of different conductive materials, and a dielectric layer may comprise multiple dielectric materials or multiple layers of dielectric materials. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components within the context of the described example.

In this application, the use of the singular includes the plural unless specifically stated otherwise, and use of the term "and" means "and/or" unless otherwise indicated. Also, as used herein, the term "or" is intended to be inclusive when used in a series and also may be used interchangeably with "and/or," unless explicitly stated otherwise (e.g., if used in combination with "either" or "only one of"). Moreover, the use of the term "including," as well as other forms, such as "includes" and "included," should be considered non-exclusive. Also, terms such as "element" or "component" encompass both elements and components comprising one unit and elements and components that comprise more than one unit, unless specifically stated otherwise. As used herein, the phrase "at least one of" preceding a series of items, with the term "and" or "or" to separate any of the items, modifies the list as a whole, rather than each member of the list (*i.e.,* each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

Unless otherwise indicated, all numbers used herein to express quantities, dimensions, and so forth should be understood as being modified in all instances by the term "about." As used herein, the articles "a" and "an" are intended to include one or more items and may be used interchangeably with "one or more." Similarly, as used herein, the article "the" is intended to include one or more items referenced in connection with the article "the" and may be used interchangeably with "the one or more." As used herein, the term "set" is intended to include one or more items (e.g., related items, unrelated items, a combination of related and unrelated items, and/or the like), and may be used interchangeably with "one or more." Where only one item is intended, the phrase "only one" or similar language is used. As used herein, the terms "has," "have," "having," or the like are intended to be open-ended terms. Further, the phrase "based on" is intended to mean "based, at least in part, on" unless explicitly stated otherwise. In the foregoing description, satisfying a threshold may, depending on the context, refer to a value being greater than the threshold, greater than or equal to the threshold, less than the threshold, less than or equal to the threshold, equal to the threshold, and/or the like, depending on the context.

Although particular combinations of features are recited in the claims and/or disclosed in the specification, these combinations are not intended to limit the disclosure of various implementations. In fact, many of these features may be combined in ways not specifically recited in the claims and/or disclosed in the specification. Thus, while each dependent claim listed below may directly depend on only one claim, the disclosure of various implementations includes each dependent claim in combination with every other claim in the claim set. No element, act, or instruction used herein should be construed as critical or essential unless explicitly described as such.

## Claims

1. A semiconductor device, comprising:
a channel;
a source disposed on the channel;
a drain disposed on the channel;
a first gate comprising a first metal disposed on the channel between the source and the drain;
. a second gate comprising a second metal disposed on the channel between the first gate and the drain, the second metal being different from the first metal; and
a native region disposed below at least a portion of the channel.

2. The semiconductor device of claim 1, further comprising:
a p-type well; and
an n-type well.

3. The semiconductor device of claim 2, wherein:
the native region is disposed within the p-type well and/or displaces at least a portion of the p-type well.

4. The semiconductor device of claim 2 or 3, wherein:
the native region is disposed within the p-type well and/or displaces at least a portion of the n-type well.

5. The semiconductor device of any preceding claim 2 to 4, wherein:
a first portion of the native region is disposed within the p-type well and/or displaces at least a portion of the p-type well; and
a second portion of the native region is disposed within the n-type well and/or displaces at least a portion of the n-type well.

6. The semiconductor device of any preceding claim 2 to 5, wherein:
the native region separates the p-type well from the n-type well.

7. The semiconductor device of any preceding claim 2 to 6, wherein:
the native region shares a layer with the p-type well and/or the n-type well and is more lightly doped than the p-type well and/or the n-type well.

8. The semiconductor device of any preceding claim, wherein:
the native region is disposed at least partially beneath the first gate.

9. The semiconductor device of any preceding claim, wherein:
the native region is disposed at least partially beneath the second gate.

10. The semiconductor device of any preceding claim, wherein:
the native region is disposed at least partially beneath the first gate and the second gate.

11. The semiconductor device of any preceding claim, further comprising a substrate, wherein the native region and the substrate are doped at approximately the same level.

12. The semiconductor device of any preceding claim, further comprising a substrate, wherein the native region is contiguous with the substrate.

13. The semiconductor device of any preceding claim, wherein the second metal is different from the first metal such that the first gate has a first threshold voltage and the second gate has a second threshold voltage, the second threshold voltage being greater than the first threshold voltage.

14. A semiconductor device, comprising:
a substrate;
a channel;
a p-type well;
an n-type well;
a source disposed on the channel;
a drain disposed on the channel;
a first gate comprising a first metal disposed on the channel between the source and the drain; .
a second gate comprising a second metal disposed on the channel between the first gate and the drain, the second metal being different from the first metal; and
a native region.

15. A semiconductor device, comprising:
a substrate;
a channel;
a source disposed on the channel;
a drain disposed on the channel;
a first gate comprising a first metal disposed on the channel between the source and the drain;
a second gate comprising a second metal disposed on the channel between the first gate and the drain, the second metal being different from the first metal; and
a native region contiguous with the substrate and in direct contact with at least a portion of the channel.
